# EUROPEAN PATENT SPECIFICATION

(11) **EP 1 528 676 B1**
(45) Date of publication and mention of the grant of the patent: **13.09.2006**
(21) Application number: 04015551.7
(22) Date of filing: 01.07.2004
(51) Int. Cl.: H03H 9/58

(54) **Film acoustically-coupled transformer with reverse c-axis piezoelectric material**
Akustisch gekoppelter Dünnschicht-Transformator mit piezoelektrischem Material, welches entgegengesetzte C-Axen Orientierung besitzt
Transformateur à couplage acoustique de couches minces avec matériel piézoélectrique à axe-c inversée

(30) Priority: 30.10.2003 US 699481; 29.04.2004 US 836653
(43) Date of publication of application: 04.05.2005
(73) Proprietor: Avago Technologies General IP (Singapore) Pte. Ltd, Singapore 768923 (SG)
(72) Inventor: Larson, John D. III, Palo Alto, CA 94301 (US); Oshmyansky, Yury, Laguna Beach, CA 92651 (US)
(74) Representative: Liesegang, Roland

(56) References cited:
- US-A1- 2003 128 081
- REINHARDT A ET AL INSTITUTE OF ELECTRICAL AND ELECTRONICS ENGINEERS: "Design of coupled resonator filters using admittance and scattering matrices" 2003 IEEE ULTRASONICS SYMPOSIUM PROCEEDINGS. HONOLULU, HAWAII, OCT. 5, vol. VOL. 1 OF 2, 5 October 2003 (2003-10-05), pages 1428-1431, XP010701841 ISBN: 0-7803-7922-5
- YANG C-M ET AL INSTITUTE OF ELECTRICAL AND ELECTRONICS ENGINEERS: "Highly C-axis-oriented AIN film using MOCVD for 5GHz-band FBAR filter" 2003 IEEE ULTRASONICS SYMPOSIUM PROCEEDINGS. HONOLULU, HAWAII, OCT. 5, vol. VOL. 1 OF 2, 5 October 2003 (2003-10-05), pages 170-173, XP010701064 ISBN: 0-7803-7922-5
- JUN-PHIL JUNG ET AL: "Experimental and theoretical investigation on the relationship between AIN properties and AIN-based FBAR characteristics" PROCEEDINGS OF THE 2003 IEEE INTERNATIONAL FREQUENCY CONTROL SYMPOSIUM& PDA EXHIBITION JOINTLY WITH THE 17TH. EUROPEAN FREQUENCY AND TIME FORUM. TAMPA, FL, MAY 4 - 8, 2003, IEEE INTERNATIONAL FREQUENCY CONTROL SYMPOSIUM, NEW YORK, NY : IEEE, US, 4 May 2003 (2003-05-04), pages 779-784, XP010688959 ISBN: 0-7803-7688-9

## Description

### Background

Transformers are used in many types of electronic device to perform such functions as transforming impedances, linking single-ended circuitry with balanced circuitry or vice versa and providing electrical isolation. However, not all transformers have all of these properties. For example, an autotransformer does not provide electrical isolation.

Transformers operating at audio and radio frequencies up to VHF are commonly built as coupled primary and secondary windings around a high permeability core. Current in the windings generates a magnetic flux. The core contains the magnetic flux and increases the coupling between the windings. A transformer operable in this frequency range can also be realized using an optical-coupler. An opto-coupler used in this mode is referred to in the art as an opto-isolator.

In transformers based on coupled windings or opto-couplers, the input electrical signal is converted to a different form (i.e., a magnetic flux or photons) that interacts with an appropriate transforming structure (i.e., another winding or a light detector), and is re-constituted as an electrical signal at the output. For example, an opto-coupler converts an input electrical signal to photons using a light-emitting diode. The photons pass through an optical fiber or free space that provides isolation. A photodiode illuminated by the photons generates an output electrical signal from the photon stream. The output electrical signal is a replica of the input electrical signal

At UHF and microwave frequencies, coil-based transformers become impractical due to such factors as losses in the core, losses in the windings, capacitance between the windings, and a difficulty to make them small enough to prevent wavelength-related problems. Transformers for such frequencies are based on quarter-wavelength transmission lines, e.g., Marchand type, series input/parallel output connected lines, etc. Transformers also exist that are based on micro-machined coupled coils sets and are small enough that wavelength effects are unimportant. However such transformers have issues with high insertion loss.

All the transformers just described for use at UHF and microwave frequencies have dimensions that make them less desirable for use in modem miniature, high-density applications such as cellular telephones. Such transformers also tend to be high in cost because they are not capable of being manufactured by a batch process and because they are essentially an off-chip solution. Moreover, although such transformers typically have a bandwidth that is acceptable for use in cellular telephones, they typically have an insertion loss greater than 1 dB, which is too high.

Opto-couplers are not used at UHF and microwave frequencies due to the junction capacitance of the input LED, non-linearities inherent in the photodetector, limited power handling capability and insufficient isolation to give good common mode rejection.

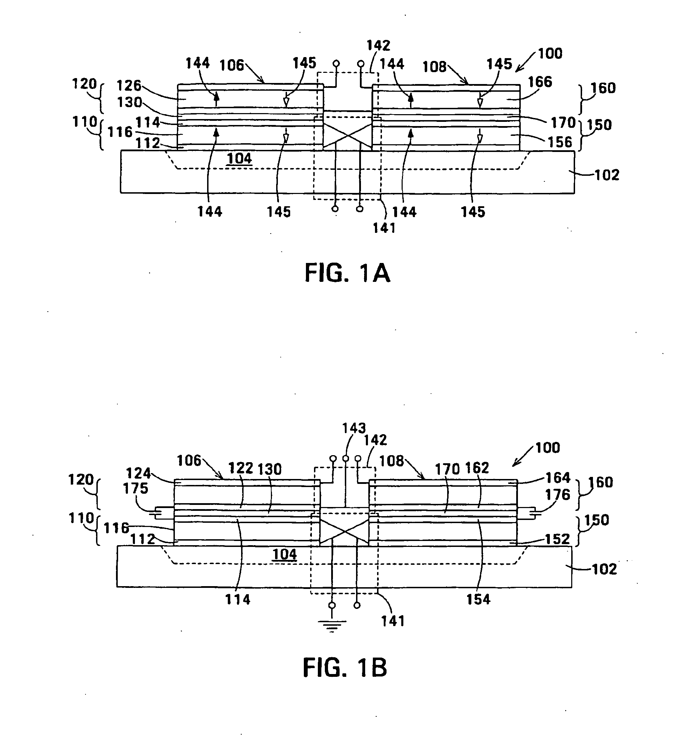

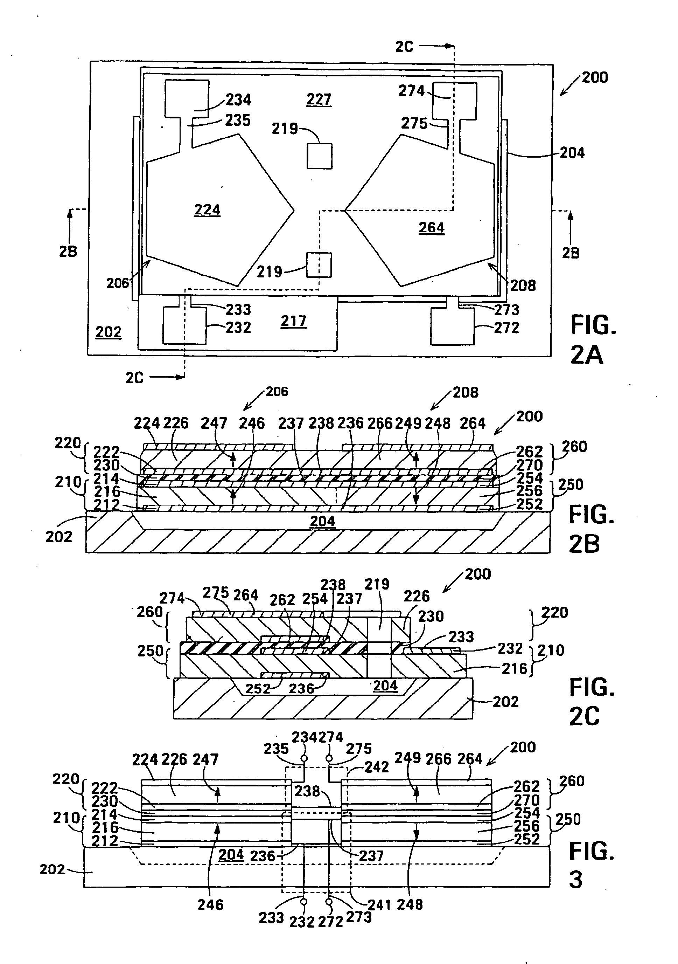

Above-mentioned United States patent application serial no. 10/699,481, of which this disclosure is a continuation-in-part, discloses a film acoustically-coupled transformer. Figure 1A schematically illustrates an embodiment 100 of such acoustically-coupled transformer. Acoustically-coupled transformer 100 has a first stacked bulk acoustic resonator (SBAR) 106 and a second SBAR 108 located above a cavity 104 in a substrate 102. Each SBAR has a stacked pair of film bulk acoustic resonators (FBARs) and an acoustic decoupler between the FBARs. Specifically, SBAR 106 has a stacked pair of FBARs 110 and 120 and an acoustic coupler 130 between them, and SBAR 108 has a stacked pair of FBARs 150 and 160 and an acoustic coupler 170 between them. Each of the FBARs has opposed planar electrodes and a layer of piezoelectric material between the electrodes. For example, FBAR 110 has opposed planar electrodes 112 and 114 with a layer 116 of piezoelectric material between them.

Acoustically-coupled transformer 100 additionally has a first electrical circuit 141 connecting one of the FBARs of SBAR 106 to one of the FBARs of SBAR 108 and a second electrical circuit 142 connecting the other of the FBARs of SBAR 106 to the other of the FBARs of SBAR 108.

In the embodiment of the above-described acoustically-coupled transformer shown in Figure 1A, electrical circuit 141 connects the respective FBARs in anti-parallel and electrical circuit 142 connects the respective FBARs in series. This embodiment has a 1:4 impedance transformation ratio between the electrical circuit 141 and electrical circuit 142 or a 4:1 impedance transformation ratio between electrical circuit 142 and electrical circuit 141.

In other embodiments, electrical circuit 141 electrically connects the one of the FBARs of SBAR 106 either in anti-parallel or in series with the one of the FBARs of SBAR 108, and electrical circuit 142 electrically connects the other of the FBARs of SBAR 106 either in anti-parallel or in series with the other of the FBARs of SBAR 108.

All embodiments of the above-described acoustically-coupled transformer are small in size, are capable of linking single-ended circuitry with balanced circuitry or vice versa, and provide electrical isolation between primary and secondary. The embodiments specifically described above are also nominally electrically balanced.

The embodiment shown in Figure 1A is of particular interest for a number of applications. However, although this embodiment is nominally electrically balanced, its common mode rejection is less than many potential applications require. Moreover, the need to connect electrodes at different levels in the FBARs connected in anti-parallel increases the complexity of fabricating this embodiment of the transformer.

What is needed, therefore, is an acoustically-coupled transformer that has the advantages of the acoustically-coupled transformer described above, but that has better common mode rejection and is simpler to fabricate.

### Summary of the Invention

In a first aspect, the invention provides a thin-film acoustically-coupled transformer that has first and second stacked bulk acoustic resonators (SBARs), each having a stacked pair of film bulk acoustic resonators (FBARs) with an acoustic decoupler between the FBARs. Each FBAR has opposed planar electrodes with a layer of piezoelectric material between the electrodes. The piezoelectric material has a c-axis. A first electrical circuit connects one FBAR of the first SBAR to one FBAR of the second SBAR, and a second electrical circuit connects the other FBAR of the first SBAR to the other FBAR of the second SBAR. The c-axis of the piezoelectric material of one of the FBARs is opposite in direction to the c-axes of the piezoelectric materials of the other three FBARs. This arrangement substantially reduces the amplitude of signal-frequency voltages across the acoustic decouplers and significantly increases the common mode rejection ratio of the transformer. This arrangement also allows conductive acoustic decouplers to be used, increasing the available choice of acoustic decoupler materials.

In a second aspect, the invention provides a method of making a thin-film acoustically-coupled transformer in which a first stacked bulk acoustic resonator and a second stacked bulk acoustic resonator (SBAR) are fabricated. In fabricating the SBARs, a lower pair of film bulk acoustic resonators (FBARs), an upper pair FBARs and acoustic decouplers between the FBARs are formed. Each of the FBARs comprises opposed planar electrodes and a layer of piezoelectric material between the electrodes. The piezoelectric material has a c-axis. Forming the pairs of FBARs comprises setting the c-axis of the piezoelectric material of one of the FBARs opposite in direction to the c-axes of the piezoelectric material of the other three FBARs. Additionally, the method comprises electrically connecting one of the FBARs of the first SBAR to one of the FBARs of the second SBAR, and electrically connecting the other of the FBARs of the first SBAR to the other of the FBARs of the second SBAR.

In one embodiment, in forming the pairs of FBARs, a metal layer is deposited and is patterned to define a pair of the electrodes, and a layer of piezoelectric material is deposited over the electrodes. The c-axis of the piezoelectric material of one of the FBARs is set opposite in direction to the c-axes of the piezoelectric material of the other three FBARs by depositing a seed layer of reverse c-axis piezoelectric material on one of the electrodes prior to depositing the layer of piezoelectric material.

In another embodiment, in forming the pairs of FBARs, a metal layer is deposited and is patterned to define a pair of the electrodes, and a layer of piezoelectric material is deposited on the electrodes. The deposited layer comprises a region of reverse c-axis material on one of the electrodes and a region of normal c-axis material on the other of the electrodes. The c-axis of the piezoelectric material of one of the FBARs is set opposite in direction to the c-axes of the piezoelectric material of the other three FBARs by depositing the regions using different deposition conditions.

In another embodiment, in forming the pairs of FBARs, a metal layer is deposited and is patterned layer to define a pair of first electrodes, a layer of ferroelectric piezoelectric material is deposited over the first electrodes, and an additional metal layer is deposited and is patterned to define pair of second electrodes opposite the first electrodes. The c-axis of the piezoelectric material of one of the FBARs is set opposite in direction to the c-axes of the piezoelectric material of the other three FBARs by applying a poling voltage of a nominal polarity between one of the first electrodes and an opposed one of the second electrodes, and by applying a poling voltage of an opposite polarity between the other of the first electrodes and the other of the second electrodes.

### Brief Description of the Drawings

Figure 1A is a schematic drawing of the electrical circuits of an embodiment of a 1:4 or 4:1 thin-film acoustically-coupled transformer in accordance with the prior art.
Figure 1B is a schematic diagram showing parasitic capacitances in the thin-film acoustically-coupled transformer shown in Figure 1A.
Figure 2A is a plan view of an example of a first embodiment of a 1:4 or 4:1 thin-film acoustically-coupled transformer in accordance with the invention.
Figures 2B and 2C are cross-sectional views of the thin-film acoustically-coupled transformer along section lines 2B-2B and 2C-2C, respectively; in Figure 2A.
Figure 3 is a schematic drawing of the electrical circuits of the thin-film acoustically-coupled transformer shown in Figure 2A-2C.
Figure 4A is an enlarged cross-sectional view of part of the acoustically-coupled transformer shown in Figure 2A along the section line 2B-2B showing a first embodiment of the acoustic decoupler.
Figure 4B is an enlarged cross-sectional view of part of the acoustically-coupled transformer shown in Figure 2A along the section line 2B-2B showing a second embodiment of the acoustic decoupler.
Figure 5 is a graph showing how the calculated frequency response of embodiments of the thin-film acoustically-coupled transformer shown in Figures 2A-2C depends on the acoustic impedance of the acoustic decoupler.
Figures 6A-6K are plan views illustrating an exemplary process for making a thin-film acoustically-coupled transformer in accordance with the invention.
Figures 6L-6V are cross-sectional views along the section lines 6L-6L, 6M-6M, 6N-6N, 60-60, 6P-6P, 6Q-6Q, 6R-6R, 6S-6S, 6T-6T, 6U-6U and 6V-6V in Figures 6A-6K, respectively.
Figures 7A and 7B are plan views of a second embodiment of a 1:4 or 4:1 thin-film acoustically-coupled transformer in accordance with the invention at respective stages of its fabrication.
Figure 7C is a cross-sectional view of the second embodiment along the section line 7C-7C in Figure 7B.
Figures 8A-8F are plan views illustrating another exemplary process for making a thin-film acoustically-coupled transformer in accordance with the invention.

### Detailed Description

A film bulk acoustic resonator (FBAR) is a polarity-dependent device as a result of polarity dependence of the piezoelectric material that constitutes part of the FBAR. A voltage of a given polarity applied between the electrodes of the FBAR will cause the thickness of the FBAR to change in a first direction, whereas the same voltage of the opposite polarity will cause the thickness of the FBAR to change in a second direction, opposite the first direction. For example, a voltage of the given polarity will cause the thickness of the FBAR to increase whereas a voltage of the opposite polarity will cause the FBAR to decrease. The thickness of the FBAR is the dimension of the FBAR between the electrodes. Similarly, a mechanical stress applied to the FBAR that causes the thickness of the FBAR to change in a first direction will generate a voltage of the given polarity between the electrodes of the FBAR, whereas a mechanical stress that causes the thickness of the FBAR to change in a second direction, opposite the first direction, will generate a voltage of the opposite polarity between the electrodes of the FBAR. For example, a mechanical stress applied to the FBAR that causes the thickness of the FBAR to increase will generate a voltage of the given polarity, whereas a mechanical stress that causes the thickness of the FBAR to decrease will generate a voltage of the opposite polarity.

Piezoelectric materials, such as aluminum nitride (AIN), in the crystal class 6mm have a hexagonal unit cell with an a-axis and a b-axis in the hexagonal plane and a c-axis orthogonal to the hexagonal plane. The direction of the c-axis of the piezoelectric material of the FBAR determines the relationship between the polarity of the voltage and the direction of change in the thickness of the FBAR. The above examples are obtained using an FBAR in which the piezoelectric material has its c-axis oriented in a given direction. In an FBAR in which the c-axis of the piezoelectric material is oriented in a second direction, opposite the first direction, a voltage of the given polarity applied between the electrodes of the FBAR will cause the thickness of the FBAR to change in the second direction, whereas a voltage of the opposite polarity will cause the thickness of the FBAR to change in a first direction. Similarly, a mechanical stress applied to the FBAR that causes the thickness of the FBAR to change in a first direction will generate a voltage of the opposite polarity between the electrodes of the FBAR whereas a mechanical stress that causes the thickness of the FBAR to change in a second direction, opposite the first direction, will generate a voltage of the given polarity between the electrodes of the FBAR. Piezoelectric material whose c-axis extends towards the substrate over which the FBAR is suspended will be referred to herein as *reverse c-axis material*. Piezoelectric material whose c-axis extends away from the substrate over which the FBARs are suspended will be referred to herein as *normal c-axis material*.

In the embodiments of the thin-film acoustically-coupled transformer described in above-mentioned United States patent application serial no. 10/699,481, such as the embodiment 100 shown in Figure 1A, the respective piezoelectric layers 116, 126, 156 and 166 of FBARs 110, 120, 150 and 160 constituting transformer 100 are layers of normal c-axis material. The direction of the c-axis of normal c-axis material is indicated by an arrow 144. Alternatively, the respective piezoelectric layers 116 and 156 of lower FBARs 110 and 150 are layers of normal c-axis material and the respective piezoelectric layers 126 and 166 of upper FBARs 120 and 160 are layers of reverse c-axis material. The direction of the c-axis of reverse c-axis material is indicated by an arrow 145. In a further alternative, the respective piezoelectric layers 116 and 156 of lower FBARs 110 and 150 are layers of reverse c-axis material and the respective piezoelectric layers 126 and 166 of upper FBARs 120 and 160 are layers of normal c-axis material.

The inventors have discovered that in an acoustically-coupled transformer with the above-described c-axis orientations, a signal-frequency voltage difference exists between the electrodes on opposite sides of acoustic decouplers 130 and 170 during normal operation of the transformer. For example, as shown in Figure 1B, when the embodiment shown in Figure 1A is used in a typical application in which electrodes 112 and 154 are grounded and electrodes 122 and 162 are connected to a center tap terminal 143, a signal-frequency voltage difference exists between electrodes 114 and 122 on opposite sides of acoustic decoupler 130. When applied to the capacitor composed of electrodes 114 and 122 and acoustic decoupler 130, this voltage difference. impairs the common mode rejection of transformer 100. The capacitance of this capacitor is shown schematically at 175. In some embodiments, a signal-frequency voltage difference additionally exists between electrodes 154 and 162 on opposite sides of acoustic decoupler 170. When applied to the capacitor composed of electrodes 154 and 162 and acoustic decoupler 170, this voltage difference further impairs the common mode rejection of transformer 100. The capacitance of this capacitor is shown schematically at 176.

The piezoelectric layer of one of the FBARs of the acoustically-coupled transformer in accordance with the invention has a c-axis opposite in direction to the c-axes of the piezoelectric layers of the remaining three FBARs. This allows the electrodes on opposite sides of the acoustic decouplers of both SBARs to be held at the same potential. The lack of a signal-frequency voltage difference across the capacitors formed by the acoustic decouplers and the adjacent electrodes renders the capacitance of capacitors irrelevant, and provides a concomitant improvement of the electrical properties of the transformer. Moreover, one of the FBARs having a piezoelectric layer with a c-axis opposite in direction to that of the remaining three FBARs eliminates the need for electrical connections between electrodes at different levels in the FBARs, which simplifies the fabrication of a transformer in accordance with the invention.

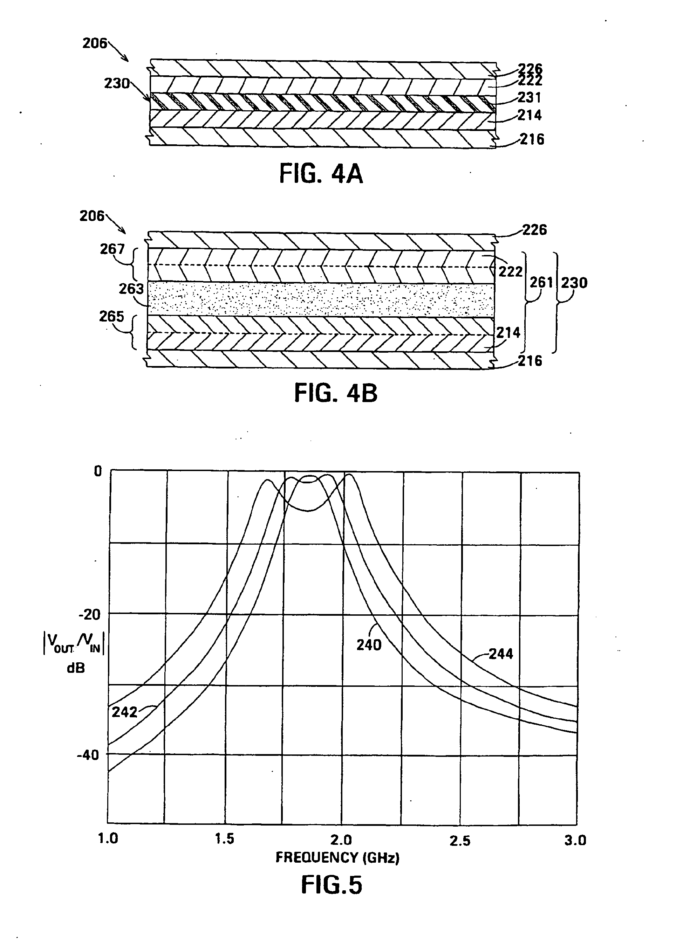

Figures 2A-2C show a plan view and two cross-sectional views, respectively, of an exemplary embodiment 200 of a thin-film acoustically-coupled transformer in accordance with the invention. Acoustically-coupled transformer 200 is capable of linking single-ended circuitry with balanced circuitry or vice versa, and has better common mode rejection than transformer 100 shown in Figure 1A. The example shown additionally provides electrical isolation between primary and secondary. Acoustically-coupled transformer 200 has an impedance transformation ratio of 1:4 or 4:1 depending which of the electrical circuits is connected to the primary terminals of the transformer. Acoustically-coupled transformer 200 has a balanced secondary when connected as a 1:4 transformer or a balanced primary when connected as a 4:1 transformer.

Acoustically-coupled transformer 200 is composed of two stacked bulk acoustic resonators (SBARs) 206 and 208. Each SBAR is composed of a stacked pair of film bulk acoustic resonators (FBARs) and an acoustic decoupler between them. Transformer 200 is additionally composed of an electrical circuit that connects one of the FBARs of SBAR 206 to one of the FBARs of SBAR 208, and an electrical circuit that connects the other of the FBARs of SBAR 206 to the other of the FBARs of SBAR 208. SBARs incorporating acoustic decouplers are described in more detail in United States patent application serial no. 10/699,289 assigned to the assignee of this disclosure and incorporated herein in its entirety by reference.

SBAR 206 is composed of a stacked pair of FBARs 210 and 220 and an acoustic decoupler 230 between them. Acoustic decoupler 230 controls the coupling of acoustic energy between FBARs 210 and 220. SBAR 208 is composed of a stacked pair of FBARs 250 and 260 and an acoustic decoupler 270 between them. Acoustic decoupler 270 controls the coupling of acoustic energy between FBARs 250 and 260.

FBAR 220 is stacked atop FBAR 210 and FBAR 260 is stacked atop FBAR 250. FBAR 210 is composed of opposed planar electrodes 212 and 214 and a layer of piezoelectric material 216 between the electrodes. FBAR 220 is composed of opposed planar electrodes 222 and 224 and a layer of piezoelectric material 226 between the electrodes. FBAR 250 is composed of opposed planar electrodes 252 and 254 and a layer of piezoelectric material 256 between the electrodes. FBAR 260 is composed of opposed planar electrodes 262 and 264 and a layer of piezoelectric material 266 between the electrodes.

SBAR 206 and SBAR 208 are suspended over a cavity 204 defined in a substrate 202. Suspending the SBARs over a cavity allows the FBARs of the SBARs to resonate mechanically. Other suspension schemes that allow the FBARs to resonate mechanically are possible. For example, the SBARs can be located over a mismatched acoustic Bragg reflector (not shown) formed in or on substrate 202, as disclosed by Lakin in United States patent no. 6,107,721, the disclosure of which is incorporated into this disclosure by reference.

The piezoelectric layer of one of the FBARs is composed of piezoelectric material whose c-axis is opposite in direction from that of the piezoelectric layers of the remaining three FBARs. In the example shown, the piezoelectric material of piezoelectric layer 256 of FBAR 250 is reverse c-axis material. The direction of the c-axis of the reverse c-axis material of piezoelectric layer 256 is indicated by an arrow 248. The piezoelectric material of the piezoelectric layers 216, 226 and 266 of the three remaining FBARs 210, 220 and 260 is normal c-axis material. The direction of the c-axes of the normal c-axis material of piezoelectric layers 216, 226 and 266 is indicated by arrows 246, 247 and 249, respectively. In other embodiments, the piezoelectric material of the piezoelectric layer of any of one of the FBARs is reverse c-axis material and the piezoelectric material of the piezoelectric layers of the remaining three FBARs is normal c-axis material. Alternatively, the piezoelectric material of the piezoelectric layer of any of one of the FBARs is normal c-axis material and the piezoelectric material of the piezoelectric layers of the remaining three FBARs is reverse c-axis material.

Figure 3 is a schematic drawing of the electrical circuits of acoustically-coupled transformer 200. A first electrical circuit 241 is composed of an electrical trace 236 that connects electrode 252 of FBAR 250 of SBAR 208 to electrode 212 of FBAR 210 of SBAR 206 and an electrical trace 237 that connects electrode 254 of FBAR 250 to electrode 214 of FBAR 210. Thus, electrical circuit 241 connects FBARs 210 and 250 in parallel. However, since the direction of the c-axis of piezoelectric layer 256 of FBAR 250 is reversed, FBARs 210 and 250 connected in parallel have the same electromechanical properties as conventional FBARs connected in anti-parallel. First electrical circuit 241 is additionally composed of an electrical trace 233 that electrically connects electrodes 212 and 252 to a terminal 232, and an electrical trace 273 that electrically connects electrodes 214 and 254 to a terminal 272. Terminals 232 and 272 are structured as bonding pads. The terms parallel and anti-parallel are described further below.

A second electrical circuit 242 is composed of an electrical trace 238 that electrically connects electrode 222 of FBAR 220 of SBAR 206 to electrode 262 of FBAR 260 of SBAR 208. Second electrical circuit 242 is additionally composed of an electrical trace 235 that electrically connects electrode 224 of FBAR 220 to a terminal 234, and an electrical trace 275 that electrically connects electrode 264 of FBAR 260 to a terminal 274. Since the directions of the c-axes of piezoelectric layers 226 and 266 of FBARs 220 and 260, respectively, are the same, electrical circuit 242 connects FBARs 220 and 260 in series. Terminals 234 and 274 are structured as bonding pads.

In an embodiment, terminals 232 and 272 constitute the primary terminals and the terminals 234 and 274 constitute the secondary terminals of thin-film acoustically-coupled transformer 200. So connected, acoustically-coupled transformer 200 operates as a step-up transformer. A signal applied to primary terminals 232 and 272 is output at twice the level at secondary terminals 234 and 274. Also, in a typical embodiment in which all of the FBARs 210, 220, 250 and 260 have a similar characteristic impedance, the impedance seen at primary terminals 232 and 272 is that of two FBARs in parallel, i.e., one half of the typical characteristic impedance of a single FBAR, whereas the impedance seen at secondary terminals 234 and 274 is that of two FBARs in series, i.e., twice the typical characteristic impedance of a single FBAR. Thus, acoustically-coupled transformer 200 has a 1:4 primary-to-secondary impedance ratio.

In an alternative embodiment, terminals 232 and 272 constitute the secondary terminals and terminals 234 and 274 constitute the primary terminals of thin-film acoustically-coupled transformer 200. So connected, acoustically-coupled transformer 200 operates as a step-down transformer. In this case, the signal output at secondary terminals 234 and 274 is one-half the level of the signal applied to primary terminals 232 and 272, and the primary-to-secondary impedance ratio is 4:1.

Electrical circuit 241 electrically connects FBARs 210 and 250 in parallel so that an input electrical signal applied to terminals 232 and 272 is applied equally and in phase to FBARs 210 and 250. An electrical signal applied to terminals 232 and 272 that causes FBAR 210 to contract mechanically causes FBAR 250 to expand mechanically by the same amount, and vice versa, due to the opposed directions of the c-axes of piezoelectric layers 216 and 256 of FBARs 210 and 250, respectively. The acoustic energy generated by FBAR 250 is therefore in antiphase with the acoustic energy generated by FBAR 210. Consequently, the acoustic energy received by FBAR 260 from FBAR 250 is in antiphase with the acoustic energy received by FBAR 220 from FBAR 210, and the signal on electrode 264 is in antiphase with the signal on electrode 224. Electrical circuit 242 connects FBARs 220 and 260 in series so that the voltage difference between terminals 234 and 274 is twice the voltage across either of FBARs 220 and 260.

Substantially the same capacitance exists between each of terminals 234 and 274 and substrate 202. Thus, circuit 242 of thin-film acoustically-coupled transformer 200 is electrically balanced. Moreover, in a typical application, terminal 272 is grounded and terminals 234 and 274 swing symmetrically about ground, so that the amplitude of any a.c. signal across acoustic decouplers 230 and 270 is small. The capacitance between the electrodes on opposite sides of the acoustic decouplers (similar to capacitances 175 and 176 shown in Figure 1B) therefore has little effect on the electrical balance of circuit 242. Accordingly, transformer 200 has better common mode rejection than transformer 100 shown in Figure 1A. Moreover, the lack of any a.c. signal across the acoustic decouplers allows electrically-conducting materials to be used in the acoustic decouplers.

FBARs are disclosed by Ruby et al. in United States patent no. 5,587,620 entitled *Tunable Thin Film Acoustic Resonators and Method of Making Same,* now assigned to the assignee of this disclosure and incorporated in this disclosure by reference. Ruby's disclosure also discloses a stacked film bulk acoustic resonator (SBAR) composed of two layers of piezoelectric material interleaved with three planar electrodes. Ruby's SBAR can be regarded as being composed of a stacked pair of FBARs in which the electrode between the piezoelectric layers is common to both FBARs, and will be referred to as a common-electrode SBAR. The common electrode renders the common-electrode SBAR incapable of providing the electrical isolation between primary and secondary that is desirable in some applications. Moreover, the common electrode SBAR exhibits an extremely narrow pass bandwidth that makes it unsuitable for use in most applications. The narrow pass bandwidth is the result of the common electrode, which over-couples acoustic energy between the FBARs.

As noted above, in transformer 200 in accordance with the invention, acoustic decoupler 230 controls the coupling of acoustic energy between stacked FBARs 210 and 220 and acoustic decoupler 270 controls the coupling of acoustic energy between stacked FBARs 250 and 260. Additionally, in embodiments in which acoustic decouplers 230 and 270 are electrically insulating, acoustic decoupler 230 isolates FBAR 210 from FBAR 220, and acoustic decoupler 270 electrically isolates FBAR 250 from FBAR 260. In such embodiments, the electrical isolation provided by acoustic decouplers 230 and 270 provides electrical isolation between the primary and the secondary of transformer 200.

The acoustic coupling provided by acoustic decouplers 230 and 270 is substantially less than the acoustic coupling between the FBARs in the common electrode SBAR referred to above. As a result, FBARs 210 and 220 and FBARs 250 and 260 are not over coupled, and transformer 200 has a relatively flat response in the pass band, as will be described below with reference to Figure 5.

The embodiment of the acoustic decouplers 230 and 270 shown in Figures 2A-2C is a first embodiment in which acoustic decoupler 230 is composed of layer of acoustic decoupling material located between the electrode 214 of FBAR 210 and the electrode 222 of FBAR 220, and acoustic decoupler 270 is composed of layer of acoustic decoupling material located between the electrode 254 of FBARs 250 and the electrode 262 of FBAR 260.

Figure 4A is an enlarged view showing in more detail part of SBAR 206 incorporating the above-mentioned first embodiment of acoustic decoupler 230. Referring additionally to Figures 2A and 2B, the corresponding part of SBAR 208 and acoustic decoupler 270 are similar in structure and will not be independently described. In the example shown, acoustic decoupler 230 is composed of a layer 231 of acoustic decoupling material located between the electrode 214 of FBAR 210 and electrode 222 of FBAR 220. Layer 231 of acoustic decoupling material additionally extends between the electrode 244 of FBAR 250 and electrode 262 of FBAR 260 to provide the acoustic decoupling layer 270 of SBAR 208. In other embodiments, independent but similar layers of acoustic decoupling material provide acoustic decouplers 230 and 270, respectively.

Important properties of the acoustic decoupling material of layer 231 are an acoustic impedance significantly different from, and typically significantly less than that of the materials of FBARs 210, 220, 250 and 260, and a nominal thickness that is an odd integral multiple of one quarter of the wavelength in the acoustic decoupling material of an acoustic wave having a frequency equal to the center frequency of the pass band of acoustically-coupled transformer 200. In some applications, a high electrical resistivity is also desirable. In embodiments in which the material of layer 231 is electrically insulating, a low dielectric permittivity is also desirable.

The acoustic decoupling material has an acoustic impedance less that of the materials of the FBARs 210, 220, 250 and 260 and substantially greater than that of air. The acoustic impedance of a material is the ratio of stress to particle velocity in the material and is measured in Rayleighs, abbreviated as *rayl*. The materials of the FBARs are typically aluminum nitride (AIN) as the material of piezoelectric layers 216, 226, 256 and 266 and molybdenum (Mo) as the material of electrodes 212, 214, 222, 224, 252, 254, 262 and 264. The acoustic impedances of the materials of the FBARs are typically greater than 30 Mrayl (35 Mrayl for AlN and 63 Mrayl for Mo) and the acoustic impedance of air is about 1 krayl. In embodiments of transformer 200 in which the materials of the FBARs are as stated above, materials with an acoustic impedance in the range from about 2 Mrayl to about 16 Mrayl work well as the acoustic coupling material of layer 231.

Figure 5 is a graph showing how the calculated frequency response of thin-film acoustically-coupled transformer 200 depends on the acoustic impedance of the acoustic decoupling material of layer 231 that constitutes the first embodiment of acoustic decouplers 230 and 270. The embodiment illustrated has a center frequency of about 1.9 GHz. Calculated frequency responses for embodiments in which the acoustic decoupling material of the acoustic decoupler has acoustic impedances of about 4 Mrayl (polyimide―curve 240), 8 Mrayl (curve 242) and 16 Mrayl (curve 244) are shown. It can be seen that the bandwidth of transformer 200 increases with increasing acoustic impedance of the acoustic decoupling material. In the embodiment in which the acoustic impedance is 16 Mrayl, the resonances of the FBARs are over coupled, which causes the characteristic double peak in the pass band response.

In the embodiment of thin-film acoustically-coupled transformer 200 shown in Figures 2A-2C, the thickness of the layer 231 (Figure 4A) of acoustic decoupling material that constitutes acoustic decouplers 230 and 270 has a nominal thickness equal to one quarter of the wavelength in the acoustic decoupling material of an acoustic wave having a frequency equal to the center frequency of the transformer's pass band, i.e., *t ≈* λ_{*n*}/4, where *t* is the thickness of layer 231 and λ_{*n*} is the wavelength in the acoustic decoupling material of an acoustic wave having a frequency equal to the center frequency of the pass band of transformer 200. A thickness of layer 231 within approximately ± 10% of the nominal thickness can alternatively be used. A thickness outside this range can alternatively be used with some degradation in performance. However, the thickness of layer 231 should differ significantly from 0λ_{*n*} at one extreme and λ_{*n*}/2 at the other extreme.

More generally, layer 231 of acoustic decoupling material has a nominal thickness equal to an odd integral multiple of one quarter of the wavelength in the acoustic decoupling material of an acoustic wave having a frequency equal to the center frequency of the pass band of transformer 200, i.e., *t ≈* (2m + 1)λ_{*n*}/4, where *t* and λ_{*n*} are as defined above and m is an integer equal to or greater than zero. In this case, a thickness of layer 231 that differs from the nominal thickness by approximately ± 10% of λ_{*n*}/4 can alternatively be used. A thickness tolerance outside this range can be used with some degradation in performance, but the thickness of layer 231 should differ significantly from an integral multiple of λ_{*n*}/2.

Many plastic materials have acoustic impedances in the range stated above and can be applied in layers of uniform thickness in the thickness ranges stated above. Such plastic materials are therefore potentially suitable for use as the acoustic decoupling material of layer 231 that constitutes acoustic decouplers 230 and 270. However, the acoustic decoupling material must also be capable of withstanding the temperatures of the fabrication operations performed after layer 231 has been deposited on electrodes 214 and 254 to form acoustic decouplers 230 and 270. As will be described in more detail below, in practical embodiments of thin-film acoustically-coupled transformer 200, electrodes 222, 224 262 and 264 and piezoelectric layers 226 and 266 are deposited by sputtering after layer 231 has been deposited. Temperatures as high as 300 °C are reached during these deposition processes. Thus, a plastic that remains stable at such temperatures is desirable as the acoustic decoupling material of layer 231.

Plastic materials typically have a very high acoustical attenuation per unit length compared with the other materials of SBARs 206 and 208. However, since the thickness of layer 231 of plastic acoustic decoupling material is typically less than 1 µm, the acoustic attenuation introduced by acoustic decouplers 230 and 270 is typically negligible.

In one embodiment, polyimide is used as the acoustic decoupling material of layer 231. Polyimide is sold under the trademark Kapton® by E.I. du Pont de Nemours and Company. In such embodiment, acoustic decouplers 230 and 270 are composed of layer 231 of polyimide applied to electrodes 214 and 254 by spin coating, spraying, dipping or another suitable method. Polyimide has an acoustic impedance of about 4 Mrayl. In another embodiment, a poly(para-xylylene) is used as the acoustic decoupling material of layer 231. In such embodiment, acoustic decouplers 230 and 270 are composed of layer 231 of poly(para-xylylene) applied to electrodes 214 and 254 by vacuum deposition. Poly(para-xylylene) is also known in the art as *parylene.* The dimer precursor di-para-xylylene from which parylene is made and equipment for performing vacuum deposition of layers of parylene are available from many suppliers. Parylene has an acoustic impedance of about 2.8 Mrayl.

In an alternative embodiment, the acoustic decoupling material of layer 231 has an acoustic impedance substantially greater than the materials of FBARs 210, 220, 250 and 260. No materials having this property are known at this time, but such materials may become available in future, or lower acoustic impedance FBAR materials may become available in future. The thickness of layer 231 of such high acoustic impedance acoustic decoupling material is as described above.

In another alternative embodiment for use in applications in which DC isolation between primary and secondary is unimportant or in which an electrical connection between one side of the primary and a center tap of the secondary or an electrical connection between a center tap of the primary and one side of the secondary is desirable, the acoustic decoupling material of layer 231 constituting acoustic decouplers 230 and 270 is electrically conducting. In one embodiment, the acoustic decoupling material is a metal such as aluminum. In another embodiment, the acoustic decoupling material is a plastic material loaded with a metallic powder having a sufficient density to provide a conductive path between opposite sides of layer 231. For example, polyimide loaded with particles of carbon having a size in the range from about 1 nm to 10 nm is applied by spin coating or another suitable deposition process to form layer 231.

Figure 4B is an enlarged view showing in more detail part of SBAR 206 incorporating a second embodiment of acoustic decoupler 230 that incorporates a Bragg structure 261. The corresponding part of SBAR 208 incorporating such second embodiment of acoustic decoupler 270 is similar in structure and will not be independently described. Bragg structure 261 is composed of a low acoustic impedance Bragg element 263 sandwiched between high acoustic impedance Bragg elements 265 and 267. Low acoustic impedance Bragg element 263 is a layer of a low acoustic impedance material whereas high acoustic impedance Bragg elements 265 and 267 are each a layer of high acoustic impedance material. The acoustic impedances of the Bragg elements are characterized as "low" and "high" with respect to one another and additionally with respect to the acoustic impedance of the piezoelectric material of layers 216 and 226. In some embodiments, at least one of the Bragg elements additionally has a low dielectric permittivity. In some applications, at least one of the Bragg elements additionally has a high electrical resistivity to provide electrical insulation between primary and secondary.

Each of the layers constituting Bragg elements 261, 263 and 265 has a nominal thickness equal to an odd integral multiple of one quarter of the wavelength in the material of the layer of an acoustic wave having a frequency equal to the center frequency of transformer 200. Layers that differ from the nominal thickness by approximately ± 10% of one quarter of the wavelength can alternatively be used. A thickness tolerance outside this range can be used with some degradation in performance, but the thickness of the layers should differ significantly from an integral multiple of one-half of the wavelength.

In an embodiment, low acoustic impedance Bragg element 263 is a layer of silicon dioxide (SiO₂), which has an acoustic impedance of about 13 Mrayl, and each of the high acoustic impedance Bragg elements 265 and 267 is a layer of the same material as electrodes 214 and 222, respectively, i.e., molybdenum, which has an acoustic impedance of about 63 Mrayl. Using the same material for high acoustic impedance Bragg elements 265 and 267 and electrodes 214 and 222, respectively, of FBARs 210 and 220, respectively, allows high acoustic impedance Bragg elements 265 and 267 additionally to serve as electrodes 214 and 222, respectively.

In an example, high acoustic impedance Bragg elements 265 and 267 have a nominal thickness equal to one quarter of the wavelength in molybdenum of an acoustic wave having a frequency equal to the center frequency of the pass band of transformer 200, and low acoustic impedance Bragg element 263 had a nominal thickness equal to three quarters of the wavelength in SiO₂ of an acoustic wave having a frequency equal to the center frequency of the pass band of the transformer. Using a three-quarter wavelength-thick layer of SiO₂ instead of a one-quarter wavelength thick layer of SiO₂ as low acoustic impedance Bragg element 263 reduces the capacitance between FBARs 210 and 220, but reduces the bandwidth of transformer 200.

In embodiments in which the acoustic impedance difference between high acoustic impedance Bragg elements 265 and 267 and low acoustic impedance Bragg element 263 is relatively low, Bragg structure 261 may be composed of more than one (e.g., n) low acoustic impedance Bragg element interleaved with a corresponding number (i.e., n + 1) of high acoustic impedance Bragg elements. For example, the Bragg structure may be composed of two low acoustic impedance Bragg elements interleaved with three high acoustic impedance Bragg elements. Only one of the Bragg elements need be insulating.

In an embodiment, low acoustic impedance Bragg element 263 additionally extends between the electrodes 254 and 262 of SBAR 208 and provides parts of acoustic decouplers 230 and 270. Additionally, electrodes 254 and 262 have nominal thicknesses equal to one quarter of the wavelength in the electrode material of an acoustic wave having a frequency equal to the center frequency of the pass band of transformer 200. Alternatively, acoustic decouplers 230 and 270 may incorporate respective independent but similar low acoustic impedance Bragg elements.

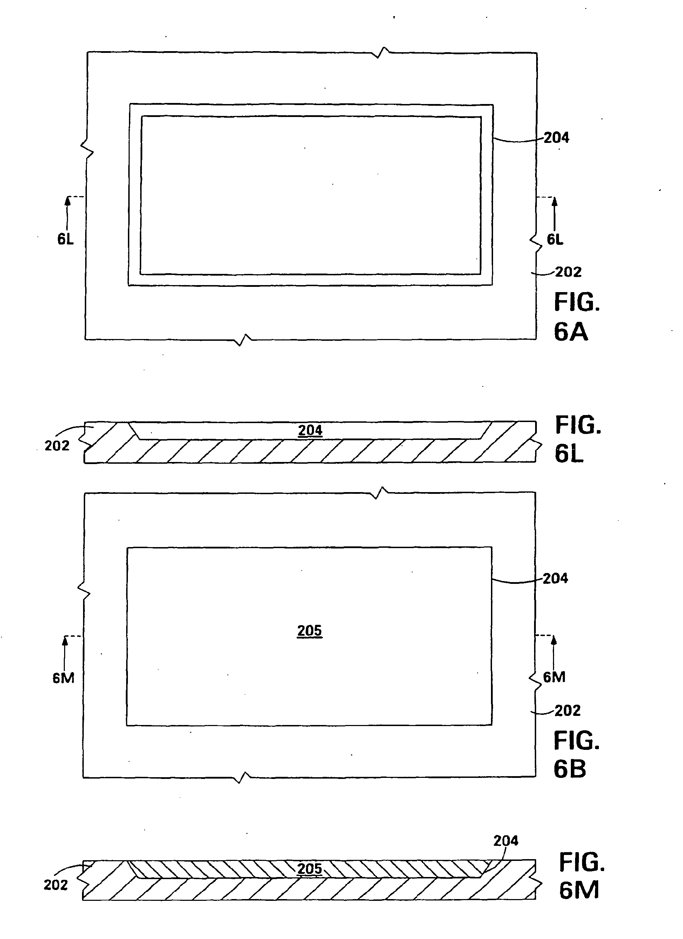

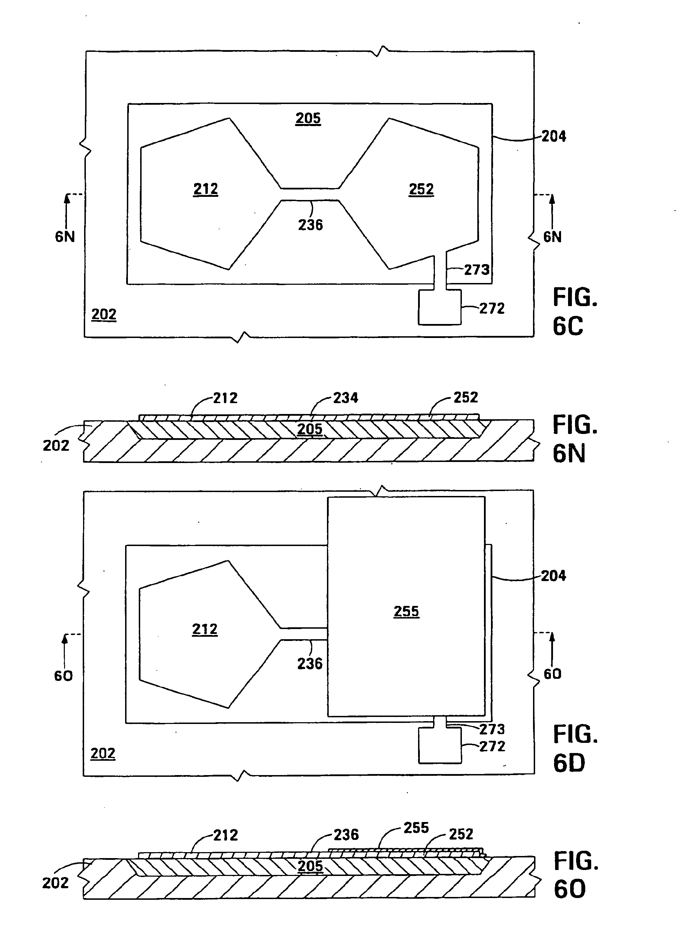

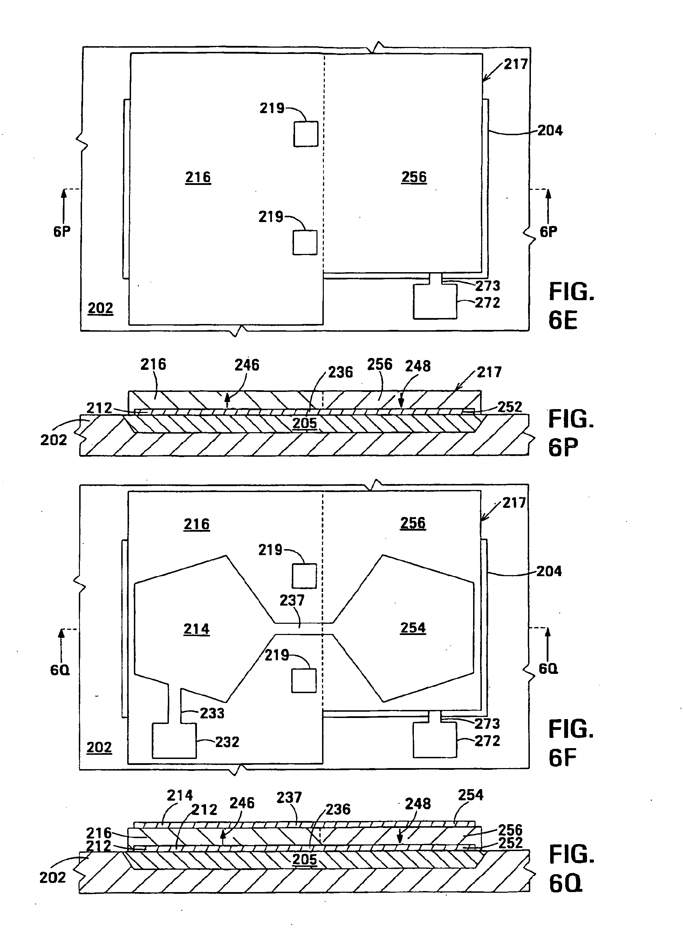

Thousands of thin-film acoustically-coupled transformers similar to thin-film acoustically-coupled transformer 200 are fabricated at one time by wafer-scale fabrication. Such wafer-scale fabrication makes thin-film acoustically-coupled transformer 200 inexpensive to fabricate. An exemplary fabrication method will be described next with reference to the plan views of Figures 6A-3K and the cross-sectional views of Figures 6L-6V. The quantitative examples set forth below relate to an example of thin-film acoustically-coupled transformer 200 suitable for operation at a frequency of about 1.9 GHz. Examples suitable for operation at other frequencies will differ in such details as electrode areas and film thicknesses.

A wafer (not shown) of single-crystal silicon is provided. A portion of the wafer constitutes, for each transformer being fabricated, a substrate corresponding to the substrate 202 of transformer 200. Figures 6A-6K and Figures 6L-6V illustrate and the following description describes the fabrication of transformer 200 in and on a portion of the wafer. As transformer 200 is fabricated, the remaining transformers on the wafer are similarly fabricated.

The portion of the wafer that constitutes substrate 202 of transformer 200 is selectively wet etched to form cavity 204, as shown in Figures 6A and 6L. Cavity 204 may alternatively be formed by dry etching.

A layer of fill material (not shown) is deposited on the surface of the wafer with a thickness sufficient to fill the cavities. The surface of the wafer is then planarized to leave the cavity filled with the fill material. Figures 6B and 6M show cavity 204 in substrate 202 filled with fill material 205.

In an embodiment, the fill material was phosphosilicate glass (PSG) and was deposited using conventional low-pressure chemical vapor deposition (LPCVD). The fill material may alternatively be deposited by sputtering or by spin coating.

A layer of metal is deposited on the surface of the wafer and the fill material. The metal is patterned to define electrode 212, electrode 252, electrical trace 236 extending between electrodes 212 and 252, bonding pad 272 and electrical trace 273 extending between electrode 252 and bonding pad 272, as shown in Figures 6C and 6N. Electrode 212 and electrode 252 typically have an irregular shape in a plane parallel to the major surface of the wafer. An irregular shape minimizes lateral modes in the FBARs of which the electrodes form part, as described in United States patent no. 6,215,375 of Larson III et al., the disclosure of which is incorporated into this disclosure by reference. Electrode 212 and electrode 252 are located so that part of the surface of fill material 205 remains exposed to enable the fill material to be removed later by etching, as will be described below.

Electrodes 212, 214, 222, 224, 252, 254, 262 and 264 are formed by patterning metal layers such that, in respective planes parallel to the major surface of the wafer, electrodes 212 and 214 of FBAR 210 have the same shape, size, orientation and position, electrodes 222 and 224 of FBAR 220 have the same shape, size, orientation and position, electrodes 252 and 254 of FBAR 250 have the same shape, size, orientation and position and electrodes 262 and 264 of FBAR 260 have the same shape, size, orientation and position. Typically, electrodes 214 and 222 additionally have the same shape, size, orientation and position and electrodes 254 and 262 additionally have the same shape, size, orientation and position.

In an embodiment, the metal deposited to form electrode 212, electrode 252, trace 236, bonding pad 272 and trace 273 was molybdenum. The molybdenum was deposited with a thickness of about 440 nm by sputtering, and was patterned by dry etching to define pentagonal electrodes each with an area of about 7,000 square µm. The area of the electrodes is chosen to provide a given electrical impedance. The impedance also depends on the height of SBARs 206 and 208 and the operating frequency. Other refractory metals such as tungsten, niobium and titanium may alternatively be used as the material of electrodes 212 and 252, bonding pad 272 and traces 236 and 273. The electrodes, bonding pads and traces may alternatively comprise layers of more than one material.

Piezoelectric material is deposited and is patterned to define a piezoelectric layer 217 that provides piezoelectric layer 216 of FBAR 210 and piezoelectric layer 256 of FBAR 250. The piezoelectric material is deposited by first depositing a thin layer of reverse c-axis piezoelectric material and patterning the thin layer to define seed layer 255 over electrode 252, as shown in Figures 6D and 60. Then, a thick layer of piezoelectric material having a nominal thickness equal to the design thickness of piezoelectric layers 216 and 256 is deposited and is patterned to define piezoelectric layer 217, as shown in Figures 6E and 6P. Seed layer 255 remains in place under part of layer 217 but is not shown in Figure 6P due to its negligible thickness compared with layer 217. Piezoelectric layer 217 is patterned to expose part of the surface of fill material 205 and bonding pads 232 and 272. Piezoelectric layer 217 is additionally patterned to define windows 219 that provide access to additional parts of the surface of the fill material.

Referring again to Figures 6D and 6N, the thin layer of piezoelectric material that is patterned to define seed layer 255 is deposited under deposition conditions that promote the formation of reverse c-axis piezoelectric material. Patterning the thin layer to define seed layer 255 exposes electrode 212, part of electrical trace 236, part of the surface of fill material 205, bonding pad 272 and part of electrical trace 273. Referring again to Figures 6E and 60, the thick layer of piezoelectric material is deposited under normal deposition conditions. The piezoelectric material of the thick layer grows with the direction of its c-axis reversed in the portion deposited on seed layer 255 but with its c-axis in the normal direction elsewhere. The thick layer of piezoelectric material is patterned to define piezoelectric layer 217, which provides piezoelectric layer 216 and piezoelectric layer 256. The patterning exposes part of the surface of fill material 205, bonding pad 272 and part of electrical trace 273, and additionally forms windows 219 that provide access to additional parts of the surface of the fill material.

In an embodiment, the thin layer of piezoelectric material was aluminum nitride and was deposited with a thickness of about 40 nm by sputtering in an oxygen-rich sputtering environment. Although this deposition process could be used to deposit the entire thickness of piezoelectric layer 217, the resulting piezoelectric material typically has piezoelectric properties inferior to those of piezoelectric material grown under normal growth conditions. By depositing a thin layer of reverse c-axis material under oxygen-rich growth conditions as a seed layer, then depositing a thick layer of piezoelectric material under normal, nitrogen-rich growth conditions, the reverse c-axis piezoelectric material deposited on the seed layer has piezoelectric properties comparable with those of normal c-axis piezoelectric material. Thus, depositing layer 217 of piezoelectric material forms piezoelectric layer 216 with its c-axis (indicated by arrow 246) in the normal direction and piezoelectric layer 256 with its c-axis (indicated by arrow 248) in the reverse direction.

The thin layer of piezoelectric material was patterned to define seed layer 255 by wet etching in potassium hydroxide or by chlorine-based dry etching..

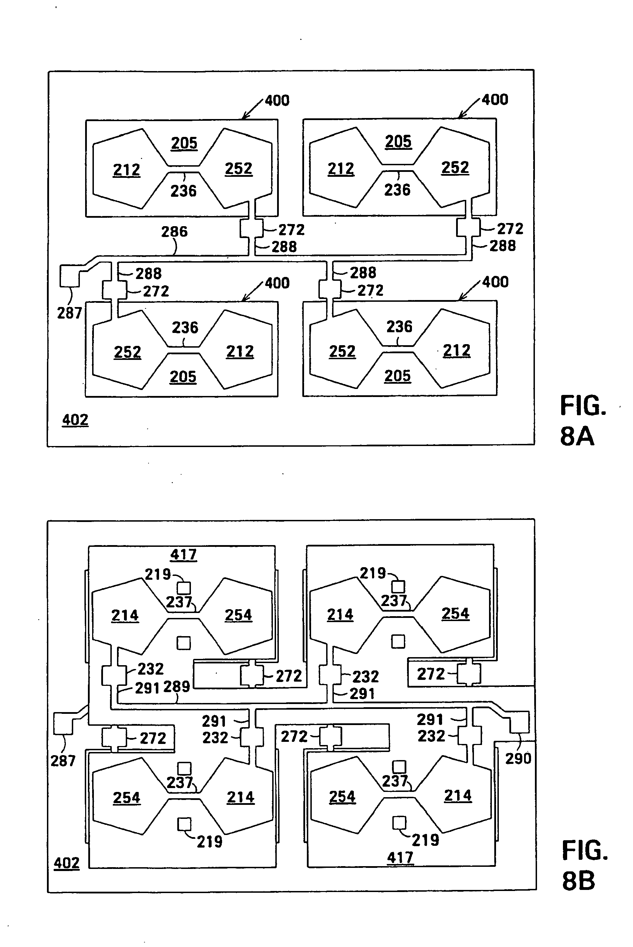

In an embodiment, the piezoelectric material deposited to form piezoelectric layer 217 was aluminum nitride and was deposited with a thickness of about 760 nm by sputtering. The piezoelectric material was patterned by wet etching in potassium hydroxide or by chlorine-based dry etching. Alternative materials for piezoelectric layer 217 include zinc oxide, cadmium sulfide and poled ferroelectric materials such as perovskite ferroelectric materials, including lead zirconium titanate, lead meta niobate and barium titanate. Poling of ferroelectric materials is described below with reference to Figures 8A-8F.

A layer of metal is deposited and is patterned to define electrode 214, electrode 254, electrical trace 237 extending between electrode 214 and electrode 254, bonding pad 232 and electrical trace 233 extending between bonding pad 232 and electrode 214, as shown in Figures 6F and 6Q.

In an embodiment, the metal deposited to form electrode 214, electrode 254, trace 237, bonding pad 232 and trace 233 was molybdenum. The molybdenum was deposited with a thickness of about 440 nm by sputtering, and was patterned by dry etching. Other refractory metals may alternatively be used as the material of electrodes 214 and 254, traces 233 and 237 and bonding pad 232. The electrodes, traces and bonding pad may alternatively comprise layers of more than one material.

A layer of acoustic decoupling material is then deposited and is patterned to define an acoustic decoupling layer 231 that provides acoustic decoupler 230 and acoustic decoupler 270, as shown in Figures 6G and 6R. Acoustic decoupling layer 231 covers at least electrode 214 and electrode 254 (Figure 6F), and is patterned to expose part of the surface of fill material 205 and bonding pads 232 and 272. Acoustic decoupling layer 231 is additionally patterned to define windows 219 that provide access to additional parts of the surface of the fill material.

In an embodiment, the acoustic decoupling material was polyimide with a thickness of about 750 nm, i.e., three quarters of a center frequency wavelength of 1.9 GHz in the polyimide. The polyimide was deposited to form acoustic decoupling layer 231 by spin coating, and was patterned by photolithography. Polyimide is photosensitive so that no photoresist is needed. As noted above, other plastic materials can be used as the acoustic decoupling material. The acoustic decoupling material can be deposited by methods other than spin coating.

In an embodiment in which the material of the acoustic decoupling layer 231 was polyimide, after deposition and patterning of the polyimide, the wafer was baked at about 300 °C before further processing was performed. The bake evaporates volatile constituents of the polyimide and prevents the evaporation of such volatile constituents during subsequent processing from causing separation of subsequently-deposited layers.

A layer of metal is deposited and is patterned to define electrode 222, electrode 262 and electrical trace 238 extending from electrode 222 to electrode 262, as shown in Figures 6H and 6S.

In an embodiment, the metal deposited to form electrodes 222 and 262 and electrical trace 238 was molybdenum. The molybdenum was deposited with a thickness of about 440 nm by sputtering, and was patterned by dry etching. Other refractory metals may alternatively be used as the material of electrodes 222 and 262 and electrical trace 238. The electrodes and trace may alternatively comprise layers of more than one material.

A layer of piezoelectric material is deposited and is patterned to define piezoelectric layer 227, as shown in Figure 6I and 6T. Depositing piezoelectric layer 227 forms piezoelectric layer 226 of FBAR 220 its c-axis (indicated by arrow 247) in the normal direction and piezoelectric layer 266 of FBAR 260 with its c-axis (indicated by arrow 249) also in the normal direction. Piezoelectric layer 227 is patterned to expose bonding pads 232 and 272 and to expose part of the surface of fill material 205. Piezoelectric layer 227 is additionally patterned to define the windows 219 that provide access to additional parts of the surface of the fill material.

In an embodiment, the piezoelectric material deposited to form piezoelectric layer 227 was aluminum nitride and was deposited with a thickness of about 760 nm by sputtering in a nitrogen-rich environment. The material of piezoelectric layer therefore grows with its c-axis in the normal direction. The piezoelectric material was patterned by wet etching in potassium hydroxide or by chlorine-based dry etching. Alternative materials for piezoelectric layer 227 include zinc oxide and lead zirconium titanate.

A layer of metal is deposited and is patterned to define electrode 224, electrode 264, bonding pad 234, electrical trace 235 extending from electrode 224 to bonding pad 234, bonding pad 274 and electrical trace 275 extending from electrode 264 to bonding pad 274, as shown in Figures 6J and 6U.

In an embodiment, the metal deposited to form electrodes 224 and 264, bonding pads 234 and 274 and electrical traces 235 and 275 was molybdenum. The molybdenum was deposited with a thickness of about 440 nm by sputtering, and was patterned by dry etching. Other refractory metals such may alternatively be used as the material of electrodes 224 and 264, bonding pads 234 and 274 and electrical traces 235 and 275. The electrodes, bonding pads and traces may alternatively comprise layers of more than one material.

A gold protective layer (not shown) is then deposited on the exposed surfaces of bonding pads 232, 234, 272 and 274.

The wafer is then isotropically wet etched to remove fill material 205 from cavity 204. As noted above, portions of the surface of fill material 205 remain exposed through, for example, windows 219. The etch process leaves thin-film acoustically-coupled transformer 200 suspended over cavity 204, as shown in Figures 6K and 6V.

In an embodiment, the etchant used to remove fill material 205 was dilute hydrofluoric acid.

The wafer is then divided into individual transformers, including transformer 200. Each transformer is then mounted in a package and electrical connections are made between bonding pads 232, 272, 234 and 274 of the transformer and pads that are part of the package.

In use, bonding pad 272 electrically connected to electrodes 212 and 252 and bonding pad 232 electrically connected to electrodes 214 and 254 provide the first terminals of the transformer 200, and bonding pad 272 electrically connected to electrode 224 and bonding pad 274 electrically connected to electrode 254 provide the second terminals of transformer 200. In one embodiment, the first terminals provide the primary terminals and the second terminals provide the secondary terminals of thin-film acoustically-coupled transformer 200. In another embodiment, the first terminals provide the secondary terminals and the second terminals provide the primary terminals of thin-film acoustically-coupled transformer 200.

The invention has been described above with reference to an embodiment in which piezoelectric layer 256 of FBAR 250 is reverse c-axis material. However, this is not critical to the invention: the piezoelectric layer of any one of the FBARs 210, 220, 250 and 260 may alternatively be reverse c-axis material. Alternatively, the piezoelectric layer of any three of the FBARs 210, 220, 250 and 260 may be reverse c-axis material, the piezoelectric layer of the remaining one of the FBARs being normal c-axis material. Moreover, electrical circuit 241 may be configured to connect FBAR 210 in series with FBAR 250 between bonding pads 272 and 272 and electrical circuit 242 may be configured to connect FBAR 220 in parallel with FBAR 260 and to bonding pads 234 and 274.

An embodiment of thin-film acoustically-coupled transformer 200 in which acoustic decouplers 230 and 270 incorporate a Bragg structure similar to that described above with reference to Figure 4B is made by a process similar to that described above. The process differs as follows:

After layer 217 of piezoelectric material has been deposited and patterned (Figures 6D, 6E, 60 and 6P), a layer of metal is deposited and is patterned in a manner similar to that shown in Figures 6F and 6Q to define high acoustic impedance Bragg elements incorporating electrodes 214 and 254, respectively, and additionally to define electrical trace 237 extending between the electrodes, bonding pad 232 and electrical trace 233 extending between electrode 214 and bonding pad 232. The high acoustic impedance Bragg elements are each similar to high acoustic impedance Bragg element 165 shown in Figure 4B. The layer of metal is deposited with a nominal thickness equal to an odd, integral multiple of one quarter of the wavelength in the metal of an acoustic wave having a frequency equal to the center frequency of the pass band of transformer 200.

In an embodiment, the metal deposited to form the high acoustic impedance Bragg elements respectively incorporating electrodes 214 and 254 is molybdenum. The molybdenum is deposited with a thickness of about 820 nm (one-quarter wavelength in Mo at about 1.9GHz) by sputtering, and is patterned by dry etching. Other refractory metals may alternatively be used as the material of the high acoustic impedance Bragg elements respectively incorporating electrodes 214 and 254. The high acoustic impedance Bragg elements may alternatively comprise layers of more than one metal.

A layer of low acoustic impedance material is then deposited and is patterned in a manner similar to that shown in Figures 6G and 6R to define a low acoustic impedance Bragg element. The layer of low acoustic impedance material is deposited with a nominal thickness equal to an odd, integral multiple of one quarter of the wavelength in the low acoustic impedance material of an acoustic wave having a frequency equal to the center frequency of the pass band of transformer 200. The low acoustic impedance Bragg element covers at least the high acoustic impedance Bragg elements, and is additionally patterned to expose part of the surface of fill material 205 and bonding pads 232 and 272. The layer of low acoustic impedance material is additionally patterned to define windows 219 that provide access to additional parts of the surface of the fill material.

In an embodiment, the low acoustic impedance material is SiO₂ with a thickness of about 790 nm. The SiO₂ is deposited by sputtering, and is patterned by etching. Other low acoustic impedance material that can be used as the material of low acoustic impedance Bragg element include phosphosilicate glass (PSG), titanium dioxide and magnesium fluoride. The low acoustic impedance material can alternatively be deposited by methods other than sputtering.

A layer of metal is deposited and is patterned in a manner similar to that shown in Figures 6H and 6S to define high acoustic impedance Bragg elements respectively incorporating electrodes 222 and 262. The layer of metal is additionally patterned to define an electrical trace 238 extending from electrode 222 to electrode 262. The layer of metal is deposited with a nominal thickness equal to an odd, integral multiple of one quarter of the wavelength in the metal of an acoustic wave having a frequency equal to the center frequency of the pass band of transformer 200.

In an embodiment, the metal deposited to form a high acoustic impedance Bragg elements respectively incorporating electrodes 222 and 262 is molybdenum. The molybdenum is deposited with a thickness of about 820 nm (one-quarter wavelength in Mo) by sputtering, and is patterned by dry etching. Other refractory metals may alternatively be used as the material of the high acoustic impedance Bragg elements respectively incorporating electrodes 222 and 262 and electrical trace 238. The high acoustic impedance Bragg elements, pads and electrical traces may alternatively comprise layers of more than one material.

Fabrication of transformer 200 is then completed using the processes described above with reference to Figures 6I-6K and 6T-6V.

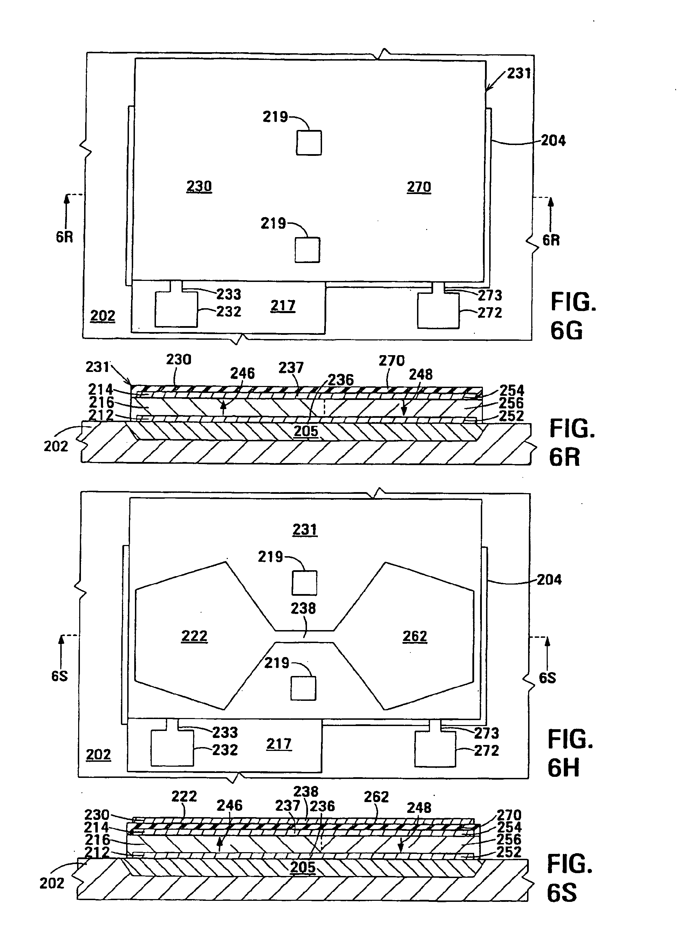

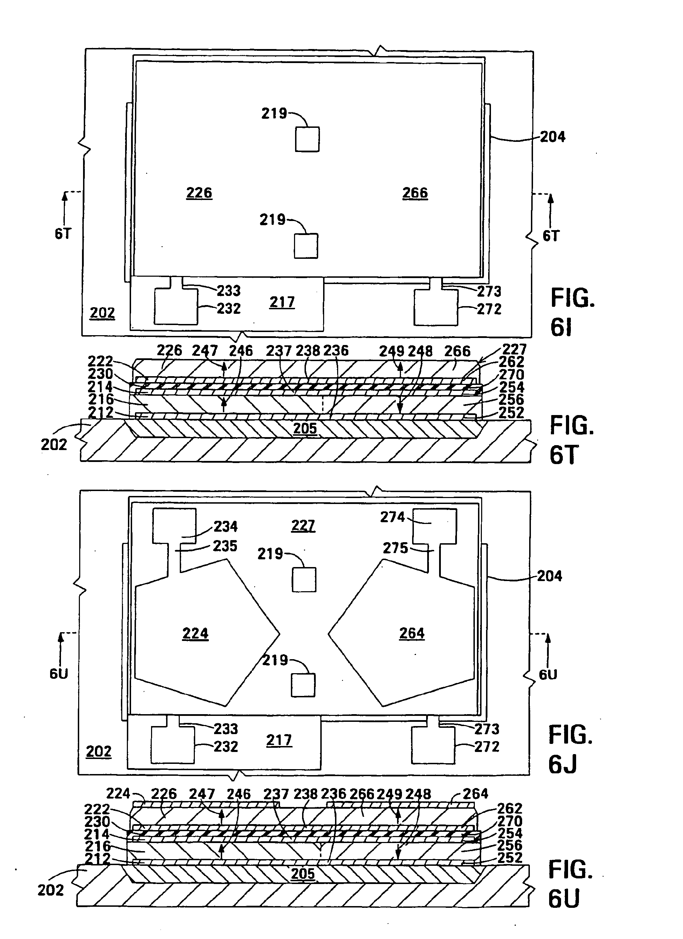

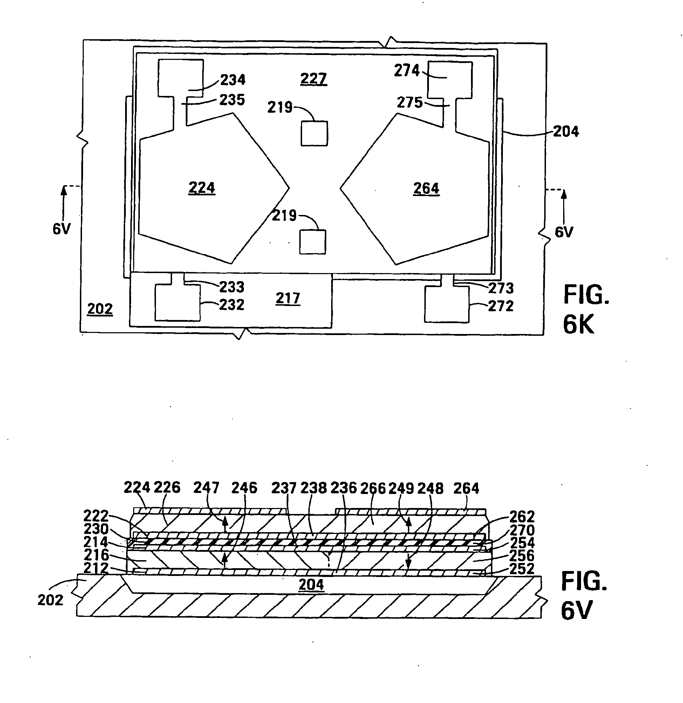

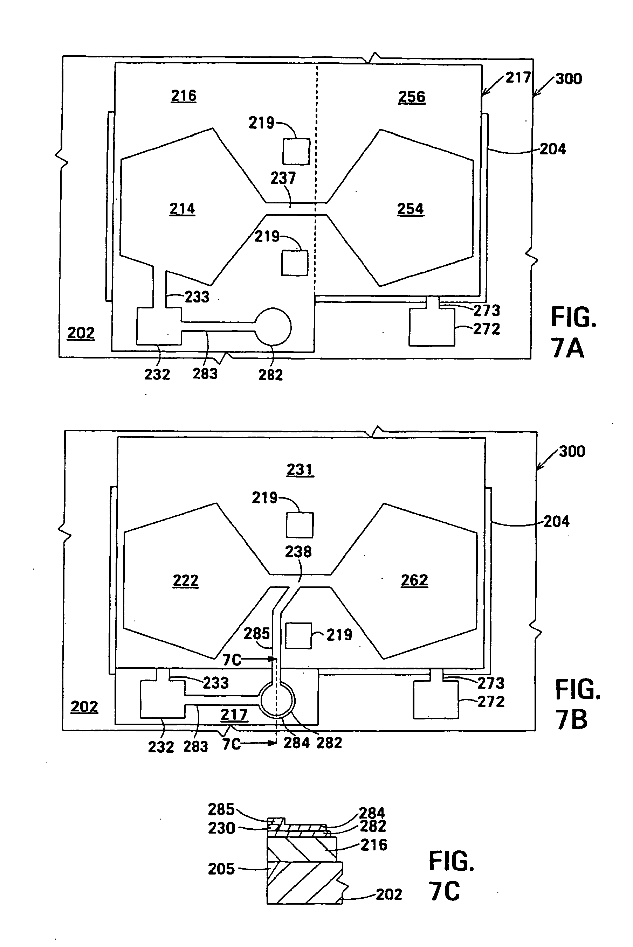

Some embodiments of an thin-film acoustically-coupled transformer in accordance with the invention incorporate an electrical connection between electrodes 214 and 222 and between electrodes 254 and 262 to hold these opposed pairs of these electrodes at the same electrical potential. This prevents the opposed pairs of electrodes from applying a voltage across the parasitic capacitor formed by acoustic decoupler 230 and electrodes 214 and 222 and the parasitic capacitor formed by acoustic decoupler 270 and electrodes 254 and 262. As noted above, electrically-conducting acoustic decouplers will provide such electrical connections. Figures 7A and 7B show an alternative embodiment 300 of a thin-film acoustically-coupled transformer in accordance with the invention at two different points in its fabrication. In this embodiment, the acoustic decouplers are electrically insulating. Elements of thin-film acoustically-coupled transformer 300 that correspond to elements of thin-film acoustically-coupled transformer 200 described above with reference to Figures 2A-2C and 3 are indicated by the same reference numerals and will not be described again in detail.

Figure 7A shows thin-film acoustically-coupled transformer 300 at the stage of its fabrication corresponding to that described above with reference to Figures 6F and 6Q. After layer 217 of piezoelectric material has been deposited and patterned as described above with reference to Figures 6E and 6P, a metal layer is deposited and is patterned to define electrode 214, electrode 254, electrical trace 237, bonding pad 232, electrical trace 233, a connection pad 282 and an electrical trace 283 extending between connection pad 282 and bonding pad 232.

In an embodiment, the metal deposited was molybdenum with a thickness of about 440 nm. The metal was deposited by sputtering and was patterned by dry etching. Other refractory metals may alternatively be used. The electrodes, traces and pads may alternatively comprise layers of more than one material.

Figure 7B shows thin-film acoustically-coupled transformer 300 at the stage of its fabrication corresponding to that described above with reference to Figures 6H and 6S. After layer 231 of acoustic decoupling material has been deposited and patterned in a manner similar to that described above with reference to Figures 6G and 6R, a metal layer is deposited and is patterned to define electrode 222, electrode 262, electrical trace 238, a connection pad 284 and an electrical trace 285 extending between connection pad 284 and electrical trace 238. Connection pad 284 overlays part of, and is electrically connected to, connection pad 282 as shown in the cross-sectional view of Figure 7C to connect electrodes 214 and 254 to electrodes 222 and 262.

In an embodiment, the metal deposited was molybdenum. with a thickness of about 440 nm. The metal was deposited by sputtering, and was patterned by dry etching. Other refractory metals may alternatively be used. The electrodes, connection pad and traces may alternatively comprise layers of more than one material.

Other embodiments incorporate other arrangements that provide an electrical connection between electrode 214 and electrode 222 and between electrode 254 and electrode 262 to minimize the signal-frequency voltage applied to the parasitic capacitors of which these electrodes form part.

Fabrication of a thin-film acoustically-coupled transformer in accordance with the invention is described above with reference to an example in which a layer of reverse c-axis piezoelectric material with good piezoelectric properties is deposited under normal deposition conditions on a thin seed layer of reverse c-axis piezoelectric material deposited under deposition conditions that promote the formation of reverse c-axis material. As noted above, an entire layer of reverse c-axis material may alternatively be deposited under deposition conditions that promote the formation of reverse c-axis material.

In such a method, the processes described above with reference to Figures 6A, 6B, 6L and 6M are performed. Then, after a metal layer is deposited and patterned to define electrodes 212 and 252, etc., as described above with reference to Figures 6C and 6N, a layer of piezoelectric material is deposited under deposition conditions that promote the formation of normal c-axis material. The normal c-axis material is patterned to expose electrode 252, part of electrical trace 236 adjacent electrode 252, bonding pad 272 and electrical trace 273. The portion of the layer of normal c-axis material that remains after the patterning is covered with a suitable etch stop layer, such as a layer of molybdenum. A layer of reverse c-axis piezoelectric material is then deposited under deposition conditions that promote the formation of reverse c-axis material. The reverse c-axis material is patterned by photolithographically-defined etching to expose the normal c-axis material covering electrode 212, and additionally to expose part of the surface of fill material 205 and bonding pads 232 and 272. The patterning additionally defines windows 219 that provide access to additional parts of the surface of the fill material. The etch stop layer protects the layer of normal c-axis material during the patterning of the layer of reverse c-axis material. The etch stop layer is then removed. Fabrication of the transformer is completed by performing the processes described above with reference to Figures 6F-6K and 6Q-6V.

In another alternative, the processes described above with reference to Figures 6A, 6B, 6L and 6M are performed. Then, after a metal layer is deposited and patterned to define electrodes 212 and 252, etc., as described above with reference to Figures 6C and 6N, a layer of piezoelectric material is deposited under deposition conditions that promote the formation of normal c-axis material. The normal c-axis material is patterned to expose electrode 252, part of electrical trace 236 adjacent electrode 252, bonding pad 272 and electrical trace 273. A layer of photoresist or other protective material is deposited and is patterned to define a window similar in shape and extent to seed layer 255 shown in Figure 6D. Electrode 252 and part of electrical trace 236 adjacent electrode 252 are exposed through the window. A layer of reverse c-axis piezoelectric material is then deposited under deposition conditions that promote the formation of reverse c-axis material. The layer of reverse c-axis piezoelectric material is then patterned using a lift-off process. The lift-off process removes all the reverse c-axis material deposited on the layer of photoresist but leaves reverse c-axis material deposited in the window defined in the photoresist. The photoresist is then removed. Fabrication of the transformer is completed by performing the processes described above with reference to Figures 6F-6K and 6Q-6V.

The normal c-axis piezoelectric material and the reverse c-axis piezoelectric material may be deposited in a reverse order to that just described.

Figures 8A-8F illustrate another way of making an embodiment 400 of a thin-film acoustically-coupled transformer in accordance with the invention. Elements of thin-film acoustically-coupled transformer 400 that correspond to elements of thin-film acoustically-coupled transformer 200 described above with reference to Figures 2A-2C and 3 are indicated by the same reference numerals and will not be described again in detail. In thin-film acoustically-coupled transformer 400, a piezoelectric ferroelectric material is used as the piezoelectric material of piezoelectric layers 217 and 227, the material of piezoelectric layer 266 is reverse c-axis material and the material of the remaining piezoelectric layers 216, 226 and 256 is normal c-axis material. Alternatively, the material of piezoelectric layer 256 may be reverse c-axis material. Piezoelectric layer 256 or 266 is made of reverse c-axis material because the directions of the c axes of the ferroelectric material constituting these layers are set by applying electric fields in opposite directions to piezoelectric layers 256 and 266, and electrodes 254 and 264 located on piezoelectric layers 256 and 266, respectively, are the only two electrodes that are not interconnected by one of electrical traces 236, 237 and 238.

Figures 8A-8F are plan views illustrating the processing of a wafer 402 to fabricate exemplary embodiments of thin-film acoustically-coupled transformers 400 similar to thin-film acoustically-coupled transformer 200 described above with referenced to Figures 2A-2C. As noted above, thousands of thin-film acoustically-coupled transformers are typically fabricated on a single wafer. However, the number of thin-film acoustically-coupled transformers shown in Figures 8A-8F has been reduced to four to simplify the drawing. The quantitative examples set forth below relate to embodiments of thin-film acoustically-coupled transformer 400 suitable for operation at a frequency of about 1.9 GHz. Embodiments suitable for operation at other frequencies will differ in such details.

First, the processes described above with reference to Figures 6A, 6B, 6L and 6M are performed. Then, a first metal layer is deposited on the wafer. In an embodiment in which the material of piezoelectric layer 417 (Figure 8B) is a perovskite ferroelectric material such as lead zirconium titanate (PZT), the material of the first metal layer is platinum or iridium. These materials are compatible with the deposition process later used to deposit piezoelectric layer 417. Alternatively, the first metal layer is composed of a layer of a refractory metal, such as molybdenum. coated with a thin protective layer of platinum or iridium. The layer of refractory metal has a thickness that differs from the design thickness of the first metal layer by the thickness of the protective layer. The protective layer provides the above-mentioned deposition process compatibility. The first metal layer is patterned to define electrodes 212 and 252, electrical trace 236, bonding pad 272 and electrical trace 273 located on fill material 205, as shown in Figure 8A and described above with reference to Figures 6C and 6N. The first metal layer is additionally patterned to define a level 1 bus 286, a level 1 contact pad 287 at one end of bus 286 and electrical traces 288 that respectively extend from the bonding pads 272 of transformers 400 to bus 286.

A first layer of piezoelectric material is then deposited and is patterned to define piezoelectric layer 417 shown in Figure 8B. Piezoelectric layer 417 provides piezoelectric layers 216 and 256 (Figure 3), and is patterned to expose part of the surface of fill material 205 and bonding pads 232 and 272. Piezoelectric layer 417 is additionally patterned to define windows 219, to cover level 1 bus 286, but to leave level 1 contact pad 287 exposed, as shown in Figure 8B. The piezoelectric material of piezoelectric layer 417 is a ferroelectric material.

In an embodiment, the ferroelectric material deposited to form piezoelectric layer 417 was lead zirconium titanate (PZT) and was deposited with a thickness of about 500 nm by a process such as RF sputtering, sol gel or metal-organic chemical vapor deposition (MOCVD). The ferroelectric material was patterned by wet etching or chlorine-based dry etching. Alternative ferroelectric materials for piezoelectric layer 317 include perovskite ferroelectric materials such as lead meta niobate and barium titanate.

A second metal layer is deposited. In an embodiment in which the material of piezoelectric layer 427 (Figure 8D) is a perovskite ferroelectric material such as lead zirconium titanate (PZT), the material of the second metal layer is platinum or iridium. These materials are compatible with the deposition process later used to deposit piezoelectric layer 427. Alternatively, the second metal layer is composed of a thin protective layer of platinum or iridium adjacent piezoelectric layer 417 and a layer of a refractory metal such as molybdenum. The layer of refractory metal has a thickness that differs from the design thickness of the second metal layer by the thickness of the protective layer. The protective layer provides above-mentioned deposition process compatibility. The second metal layer is patterned to define electrode 214, electrode 254, electrical trace 237, bonding pad 232 and electrical trace 233 as described above with reference to Figures 6F and 6Q and shown in Figure 8B. The second metal layer is additionally patterned to define a level 2 bus 289, a level 2 contact pad 290 at one end of bus 289 and electrical traces 291 that respectively extend from the bonding pads 232 of transformers 400 to bus 289.

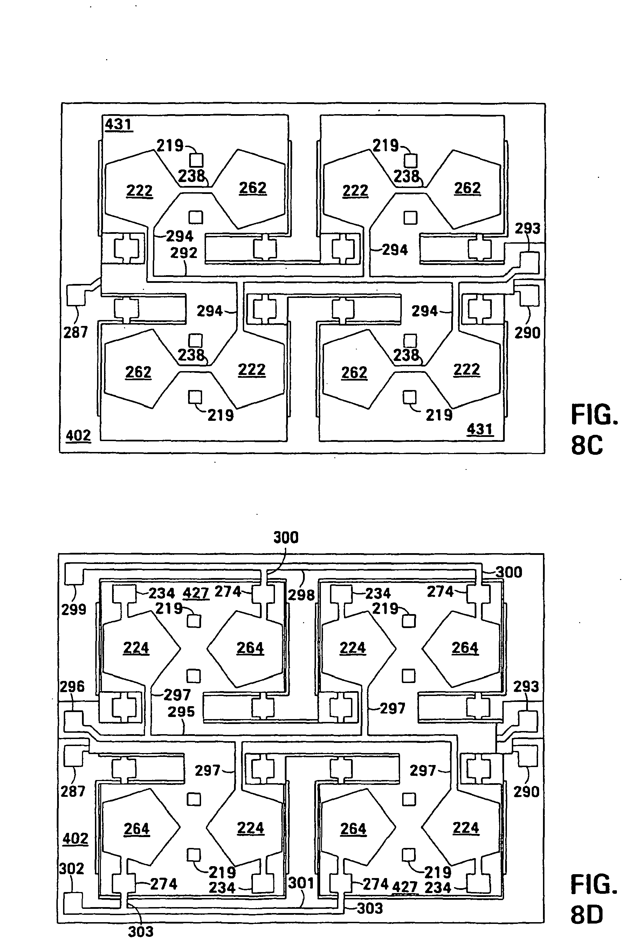

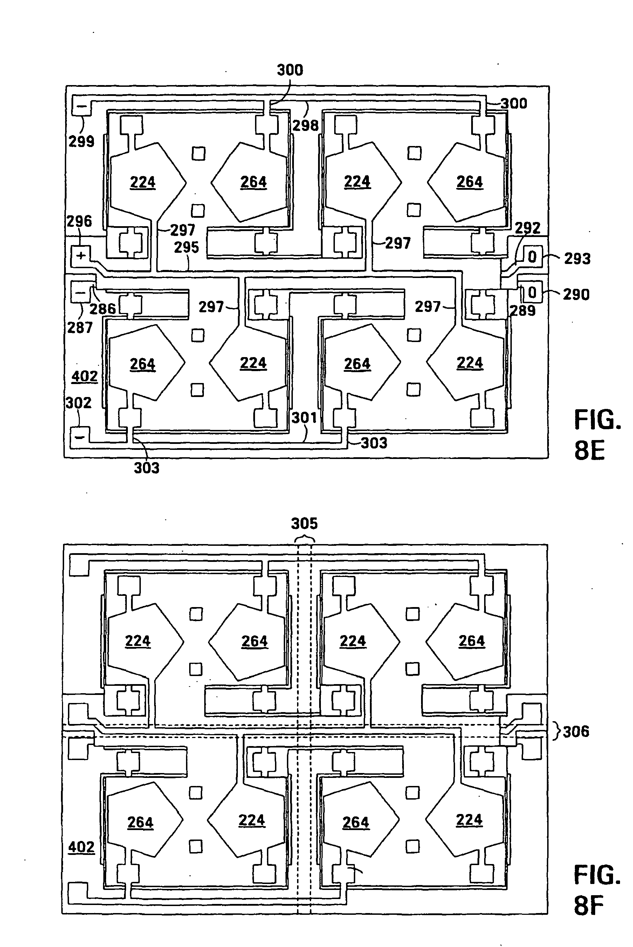

A layer of acoustic decoupling material is then deposited and is patterned to define an acoustic decoupling layer 431 that provides acoustic decoupler 230 and acoustic decoupler 270 (Figure 3), as described above with reference to Figures 6G and 6R, and as shown in Figure 8C. Acoustic decoupling layer 431 covers at least electrode 214 and electrode 254 (Figure 8B), and is patterned to expose part of the surface of fill material 205 and bonding pads 232 and 272. Acoustic decoupling layer 431 is additionally patterned to define windows 219, to cover level 2 bus 289, but to leave contact pads 287 and 290 exposed.

A third metal layer is deposited on the wafer. In an embodiment in which the material of piezoelectric layer 427 (Figure 8D) is a perovskite ferroelectric material such as lead zirconium titanate (PZT), the material of the third metal layer is platinum or iridium. These materials are compatible with the deposition process later used to deposit piezoelectric layer 427. Alternatively, the third metal layer is composed of a layer of a refractory metal, such as molybdenum, coated with a thin protective layer of platinum or iridium. The layer of refractory metal has a thickness that differs from the design thickness of the third metal layer by the thickness of the protective layer. The protective layer provides the above-mentioned deposition process compatibility. The third metal layer is patterned to define electrode 222, electrode 262 and electrical trace 238, as described above with reference to Figures 6H and 6S, and as shown in Figure 8C. The third metal layer is additionally patterned to define a level 3 bus 292, a level 3 contact pad 293 at one end of bus 292 and electrical traces 294 that respectively extend from the electrodes 222 of transformers 400 to bus 292.

A second layer of piezoelectric material is then deposited on the wafer and is patterned to define piezoelectric layer 427 shown in Figure 8D. Piezoelectric layer 427 provides piezoelectric layers 226 and 266 (Figure 3), and is patterned to expose part of the surface of fill material 205 and bonding pads 232 and 272. Piezoelectric layer 427 is additionally patterned to define windows 219, to cover level 3 bus 292, but to leave contact pads 287, 290 and 293 exposed, as shown in Figure 8D. The piezoelectric material of piezoelectric layer 427 is a ferroelectric material.

In an embodiment, the ferroelectric material deposited to form piezoelectric layer 427 was PZT and was deposited with a thickness of about 500 nm by a process such as RF sputtering, sol gel or metal-organic chemical vapor deposition (MOCVD). The ferroelectric material was patterned by wet etching or by chlorine-based dry etching. Alternative ferroelectric materials for piezoelectric layer 427 include perovskite ferroelectric materials such as lead meta niobate and barium titanate.

A fourth metal layer is deposited. The material of the fourth metal layer is a refractory metal such as molybdenum. A refractory metal can be used as the material of the fourth metal layer because no perovskite ferroelectric material deposition process is performed after the fourth metal layer is deposited. The fourth metal layer is patterned to define electrode 224, electrode 264, bonding pad 234, electrical trace 235, bonding pad 274 and electrical trace 275, as described above with reference to Figures 6H and 6S, and as shown in Figure 8D. The fourth metal layer is additionally patterned to define a first level 4 bus 295, a first level 4 contact pad 296 at one end of bus 295 and electrical traces 297 that respectively extend from the electrodes 224 of transformers 400 to bus 295. The fourth metal layer is additionally patterned to define a second level 4 bus 298, a second level 4 contact pad 299 at the end of bus 298 and electrical traces 300 that respectively extend from the bonding pads 274 of two of the transformers 400 to bus 298. The fourth metal layer is additionally patterned to define a third level 4 bus 301, a third level 4 contact pad 302 at one end of bus 301 and electrical traces 303 that respectively extend from the bonding pads 274 of the remaining two of the transformers 400 to bus 301, as shown in Figure 8D.

In an embodiment, the above-described metal layers were formed by depositing molybdenum with a thickness of about 440 nm by sputtering, and were patterned by dry etching. Alternatives similar to those described above are possible.

Referring now to Figure 8E and additionally to Figures 8A-8C, the wafer is heated to a temperature of about 125°C and poling voltages are applied to the contact pads as follows: contact pads 290 and 293 are grounded. Contact pads 287, 299 and 302 are connected to a negative poling voltage, and contact pad 296 is connected to a positive poling voltage. This arrangement of poling voltages is applied via busses 286, 289, 292, 295, 298 and 301 and traces 236, 288, 237, 291, 238, 294, 297, 300 and 303 to electrodes 212, 214, 222, 224, 252, 254, 262 and 264. The electrodes apply a poling electric field directed away from wafer 402 across the piezoelectric layers of FBARs 210, 220 and 250 (Figure 3), and apply a poling electric field directed towards wafer 402 across the piezoelectric layer of FBAR 260 (Figure 3). The poling electric fields set the c-axis of the piezoelectric layer 266 of FBAR 260 opposite in direction to the c-axes of the piezoelectric layers 216, 226 and 256 of FBARs 210, 220 and 250, respectively.

In another embodiment, poling voltages of polarities opposite those indicated are applied to the contact pads to set the c-axis of piezoelectric layer 266 opposite in direction to the c-axes of piezoelectric layers 216, 226 and 256. In another embodiment, poling voltages of polarities opposite those indicated in Figure 8E are applied to contact pads 296, 299 and 302 to set the c-axis of piezoelectric layer 256 opposite in direction to the c-axes of piezoelectric layers 216, 226 and 266. Other combinations of poling voltages may be used to set the c-axis of one of the piezoelectric layers opposite in direction to the c-axes of the other three piezoelectric layers.

In an embodiment, the poling voltages are in the range from about 250 mV to about 1 V. With piezoelectric layers 216, 226, 256 and 266 having a thickness of about 500 nm as described above, poling voltages in this range apply a poling electric field in the range from about 500 kV/m to about 2 MV/m to the piezoelectric layers.

Wafer 402 is then divided into individual thin-film acoustically-coupled transformers by a known singulation process that removes the regions of wafer 402 indicated by broken lines 305 and 306 shown in Figure 8F. The singulation process additionally separates traces 288, 291, 294, 297, 300 and 303 (Figures 8A-8D) from busses 286, 289, 292, 295, 298 and 301. This breaks the electrical connections between the electrodes formerly interconnected by the traces and busses.

Referring again to Figure 3, thin-film acoustically-coupled transformers 400 fabricated by the process just described have a circuit similar to circuit 241 that connects FBARs 210 and 250 in parallel and a circuit similar to circuit 242 that connects FBARs 250 and 260 in series. However, unlike the example shown in Figure 3, the c-axes of piezoelectric layers 216 and 256 are the same in direction and the c-axes of piezoelectric layers 226 and 266 are opposite in direction.
Consequently, FBAR 210 generates acoustic energy in phase with the acoustic energy generated by FBAR 250. The electrical signal generated by FBAR 260 is in antiphase with the electrical signal generated by FBAR 220 because the direction of the c-axis of the piezoelectric layer 266 of FBAR 260 is opposite to that of the piezoelectric layer 256 of FBAR 250. The signals on electrodes 254 and 264 of thin-film acoustically-coupled transformer 400 are in antiphase, similar to the corresponding signals in thin-film acoustically-coupled transformer 200 shown in Figure 3.

In other embodiments of a thin-film acoustically-coupled transformer in accordance with the invention in which the c-axis of the piezoelectric layer of one of the FBARs is opposite in direction to the c-axes of the piezoelectric layers of the other FBARs, electrical circuits 241 and 242 may be configured to interconnect the FBARs differently from the above-described example.

In such other embodiments, the electrical circuits 241 and 242 each electrically connect the respective FBARs in any one of a parallel, a series, an anti-parallel and an anti-series configuration. Of the sixteen possible combinations of the parallel, series, anti-parallel and anti-series electrical circuit configurations, only eight produce a working transformer. The combination of electrical circuit configurations connecting the FBARs determines the impedance and impedance transformation ratio of the transformer, i.e., 1:1 low impedance, 1:1 high impedance, 1:4 or 4:1. The single piezoelectric layer of reverse c-axis material causes an asymmetry that prevents working embodiments in which both of electrical circuits 241 and 242 are electrically balanced. In each embodiment, only one of the electrical circuits is electrically balanced. This shortcoming can be overcome by connecting the unbalanced electrical circuit to unbalanced external circuitry and vice versa. The parallel/series embodiment described in detail above additionally has good common mode rejection. The possible combinations of electrical circuit configurations are summarized in Table 1 below:

**Table 1**

| | Parallel | Series | Anti-parallel | Anti-series |
|---|---|---|---|---|
| Parallel | X | B2 1:4 | B2 1:1 LOW | X |
| Series | B1 4:1 | X | X | B1 1:1 HI |
| Anti-parallel | B1 1:1 LOW | X | X | B1 1:4 |
| Anti-series | X | B2 1:1 HI | B2 4:1 | X |

In Table 1, the row captions indicate the configuration of one of the electrical circuits, e.g., electrical circuit 241, the column captions indicate the configuration of the other of the electrical circuits, e.g., electrical circuit 242, *B1* denotes that the electrical circuit indicated by the row caption is electrically balanced, *B2* denotes that the electrical circuit indicated by the column caption is balanced, and X denotes a non-functioning transformer. The impedance transformation ratio shown is the impedance transformation from electrical terminals connected to the electrical circuit indicated by the row caption to electrical terminals connected to the electrical circuit indicated by the column caption. *LOW* denotes that the transformer has a low impedance, equivalent to that of two FBARs in parallel; *HI* indicates that the transformer has a high impedance, equivalent to that of two FBARs in series. Electrodes connected in parallel or in anti-series have in-phase voltages on them whereas electrodes connected in series or in anti-parallel have antiphase voltages on them.

The electrical circuits shown in Table 1 are subject to the constraint that an electrical circuit may only connect the electrodes of FBARs at the same level as one another in SBARs 206 and 208, i.e., one of the electrical circuits may only connect the electrodes of FBARs 210 and 250 and the other of the electrical circuits may only connect the electrodes of FBARs 220 and 260.

This disclosure describes the invention in detail using illustrative embodiments. However, the invention defined by the appended claims is not limited to the precise embodiments described.

## Claims

1. An acoustically-coupled transformer (200), comprising:
a first stacked bulk acoustic resonator, SBAR, (206) and a second SBAR (208), each SBAR comprising:
a stacked pair of film bulk acoustic resonators, FBARs, (e.g., 210, 220), each of the FBARs comprising opposed planar electrodes (e.g., 212, 214) and a layer (e.g., 216) of piezoelectric material between the electrodes, the piezoelectric material having a c-axis (e.g., 246), and
an acoustic decoupler (e.g., 230) between the FBARs;
a first electrical circuit (241) connecting one (210) of the FBARs of the first SBAR to one (250) of the FBARs of the second SBAR; and
a second electrical circuit (242) connecting the other (250) of the FBARs of the first SBAR to the other (260) of the FBARs of the second SBAR,
in which the c-axis (e.g,. 248) of the piezoelectric material of one of the FBARs (e.g., 250) is opposite in direction to the c-axes (246, 247, 249) of the piezoelectric material of the other three FBARs (210, 220, 260).

2. The transformer of claim 1, in which:
the first electrical circuit connects the one of the FBARs of the first SBAR in parallel with the one of the FBARs of the second SBAR; and
the second electrical circuit connects the other of the FBARs of the first SBAR in series with the other of the FBARs of the second SBAR.

3. The transformer of claim 1 or 2, in which the acoustic decouplers each comprise a layer (231) of acoustic decoupling material.

4. The transformer of claim 3, in which the acoustic decoupling material comprises plastic.

5. The transformer of claim 3, in which the acoustic decoupling material is electrically conducting.

6. The transformer of claim 3, 4 or 5, in which:
the transformer has a pass band **characterized by** a center frequency; and
the layer of acoustic decoupling material has a nominal thickness equal to an odd integral multiple of one quarter of the wavelength in the acoustic decoupling material of an acoustic wave having a frequency equal to the center frequency.

7. The transformer of claim 1 or 2, in which the acoustic decouplers each comprise a Bragg structure (261).

8. The transformer of any one of the preceding claims, additionally comprising an electrical connection between ones of the electrodes located on opposite sides of the acoustic decouplers.

9. A method of making an acoustically-coupled transformer (200), the method comprising:
fabricating a first stacked bulk acoustic resonator (SBAR) (206) and a second SBAR (208), the fabricating comprising:
forming lower film bulk acoustic resonators (FBARs) (210,250), upper FBARs (220, 260) and acoustic decouplers (230, 270) between the lower FBARs and the upper FBARs, each of the FBARs comprising opposed planar electrodes (e.g., 212, 214) and a layer (e.g., 216) of piezoelectric material therebetween, the piezoelectric material having a c-axis (e.g., 246), the forming comprising setting the c-axis (248) of the piezoelectric material of one of the FBARs (250) opposite in direction to the c-axes (246, 247, 249) of the piezoelectric material of the other three FBARs (210, 220, 260);
electrically connecting one of the FBARs (e.g., 210) of the first SBAR (206) to one of the FBARs (e.g., 250) of the second SBAR (208); and
electrically connecting the other of the FBARs (e.g., 220) of the first SBAR to the other of the FBARs (e.g., 260) of the second SBAR.

10. The method of claim 9, in which:
the forming comprises:
depositing and patterning a metal layer to define a pair of the electrodes (e.g., 212, 252), and
depositing a layer (e.g., 217) of piezoelectric material over the electrodes; and
the setting comprises depositing a seed layer (255) of reverse c-axis piezoelectric material on one (e.g., 252) of the electrodes prior to depositing the layer of piezoelectric material.

11. The method of claim 10, in which:
depositing the seed layer is performed under first deposition conditions that promote the formation of reverse c-axis material; and
depositing the layer of piezoelectric material is performed under second deposition conditions that promote the formation of normal c-axis material, the region (e.g., 256) of the layer deposited on the seed layer being reverse c-axis material notwithstanding its deposition under the second deposition conditions.

12. The method of claim 9, in which:
the forming comprises:
depositing and patterning a metal layer to define a pair of the electrodes (e.g., 212, 252); and
depositing a layer of piezoelectric material on the electrodes, the layer comprising a region (e.g., 256) of reverse c-axis material on one (e.g., 252) of the electrodes and a region (e.g., 216) of normal c-axis material on the other of the electrodes (e.g., 212); and
the setting comprises depositing the regions using different deposition conditions.

13. The method of claim 9, in which:
the forming comprises:
depositing a metal layer and patterning same to define a pair of first electrodes (e.g., 222, 262),
depositing a layer (e.g., 427) of ferroelectric material over the first electrodes, and
depositing an additional metal layer and patterning same to define pair of second electrodes (e.g., 224, 264) opposite the first electrodes; and
the setting comprises applying a poling voltage of a nominal polarity between one (e.g., 222) of the first electrodes and an opposed one (e.g., 224) of the second electrodes and a poling voltage of an opposite polarity between the other (e.g., 262) of the first electrodes and the other (e.g., 264) of the second electrodes:

14. The method of any one of claims 9-13, additionally comprising electrically connecting ones of the electrodes located on opposite sides of the acoustic decouplers.

## Patentansprüche

1. Akustisch gekoppelter Transformator (200), umfassend:
einen ersten gestapelten Verbund-Akustikresonator, SBAR, (206), und einen zweiten SBAR (208), wobei jeder SBAR umfaßt:
ein gestapeltes Paar von Schicht-Verbund-Akustikresonatoren, FBARs, (beispielsweise 210, 220), wobei jeder FBAR ein entgegengesetztes Paar Elektroden (beispielsweise 212, 214) und eine Schicht (beispielsweise 216) piezoelektrischen Materials zwischen den Elektroden umfaßt, wobei das piezoelektrische Material eine c-Achse (beispielsweise 246) umfaßt, und
einen akustischen Entkoppler (230) zwischen den FBARs;
einen ersten elektrischen Schaltkreis (241), der einen (210) der FBARs des ersten SBAR mit einem (250) der FBARs des zweiten SBAR verbindet; und
einen zweiten elektrischen Schaltkreis (242), der den anderen (250) der FBARs des ersten SBAR mit dem anderen (260) der FBARs des zweiten SBAR verbindet,
wobei die c-Achse (beispielsweise 248) des piezoelektrischen Materials eines FBAR (250) hinsichtlich der Richtung der c-Achsen (246, 247, 249) des piezoelektrischen Materials der anderen drei FBARs (210, 220, 260) entgegengesetzt ist.

2. Transformator nach Anspruch 1, wobei:
der erste elektrische Schaltkreis einen der FBARs des ersten SBAR parallel mit einem der FBARs des zweiten SBAR verbindet; und
der zweite elektrische Schaltkreis den anderen der FBARs des ersten SBAR seriell mit dem anderen der FBARs des zweiten SBAR verbindet.

3. Transformator nach Anspruch 1 oder 2, wobei die akustischen Entkoppler jeweils eine Schicht (231) akustisch entkoppelnden Materials umfassen.

4. Transformator nach Anspruch 3, wobei das akustisch entkoppelnde Material Kunststoff umfaßt.

5. Transformator nach Anspruch 3, wobei das akustisch entkoppelnde Material elektrisch leitend ist.

6. Transformator nach Anspruch 3, 4 oder 5, wobei:
der Transformator einen Bandpass aufweist, der durch eine Mittenfrequenz charakterisiert ist; und
die Schicht des akustisch entkoppelnden Materials eine nominale Dicke gleich einem ungeraden ganzzahligen Vielfachen einem Viertel der Wellenlänge innerhalb des akustisch entkoppelnden Materials einer akustischen Welle mit einer Frequenz gleich der Mittenfrequenz aufweist.

7. Transformator nach Anspruch 1 oder 2, wobei die akustischen Entkoppler jeweils eine Bragg-Struktur (261) umfassen.

8. Transformator nach einem der vorangehenden Ansprüche, der ferner eine elektrische Verbindung zwischen bestimmten Elektroden der Elektroden umfaßt, die auf entgegengesetzten Seiten des akustischen Entkopplers angeordnet sind.

9. Verfahren zum Herstellen eines akustisch koppelnden Transformators (200), wobei das Verfahren umfaßt:
Herstellen eines ersten gestapelten Verbund-Akustikresonators (206), SBAR, und eines zweiten SBAR (208), wobei das Herstellen umfaßt:
Ausbilden von unteren Schicht-Verbund-Akustikresonatoren (210, 250), FBARs, oberen FBARs (220, 260) und Akustik-Entkopplern (230, 270) zwischen den unteren FBARs und den oberen FBARs, wobei jeder FBAR entgegengesetzte planare Elektroden (212, 214) und eine Schicht (216) piezoelektrischen Materials zwischen diesen umfaßt, wobei das piezoelektrische Material eine c-Achse (246) umfaßt, und das Ausbilden/Einstellen der c-Achse (248) des piezoelektrischen Materials eines der FBARs (250) hinsichtlich der Richtung entgegengesetzt zu den c-Achsen (246, 247, 249) des piezoelektrischen Materials der anderen drei FBARs (210, 220, 260) umfaßt;
elektrisch Verbinden einer der FBARs (beispielsweise 210) des ersten SBAR (206) mit einem der FBARs (250) des zweiten SBAR (208); und
elektrisch Verbinden des anderen FBAR (220) des ersten SBAR mit dem anderen FBAR (260) des zweiten SBAR.

10. Verfahren nach Anspruch 9, wobei:
das Ausbilden umfaßt:
Aufbringen und Musterformen einer Metallschicht, um ein Paar der Elektroden (beispielsweise 212, 252) zu definieren, und
Aufbringen einer Schicht (beispielsweise 217) piezoelektrischen Materials über die Elektroden; wobei
das Einstellen das Aufbringen einer Keimschicht (255) piezoelektrischen Materials mit umgekehrter c-Achse auf eine (beispielsweise 252) der Elektroden vor dem Aufbringen der Schicht piezoelektrischen Materials umfaßt.

11. Verfahren nach Anspruch 10, wobei:
das Aufbringen der Keimschicht unter ersten Aufbringungsbedingungen ausgeführt wird, die das Ausbilden von Material mit umgekehrter c-Achse unterstützen; und
das Aufbringen der Schicht piezoelektrischen Materials unter zweiten Aufbringungsbedingungen ausgeführt wird, die das Ausbilden von Material mit normaler c-Achse unterstützen, wobei der Bereich (beispielsweise 256) der Schicht, die auf die Keimschicht aufgebracht wird, Material mit umgekehrter c-Achse ist, trotz seines Aufbringens unter zweiten Aufbringungsbedingungen.

12. Verfahren nach Anspruch 9, wobei:
das Ausbilden umfaßt:
Aufbringen und Musterformen einer Metallschicht, um ein Paar der Elektroden (beispielsweise 212, 252) zu definieren; und
Aufbringen einer Schicht piezoelektrischen Materials auf die Elektroden, wobei die Schicht einen Bereich (256) aus Material mit umgekehrter c-Achse auf einer (252) der Elektroden sowie einen Bereich (beispielsweise 216) aus Material mit normaler c-Achse auf der anderen der Elektroden (beispielsweise 212) umfaßt; und
das Einstellen der Bereiche mittels verschiedener Aufbringungsbedingungen umfaßt.

13. Verfahren nach Anspruch 9, wobei:
das Ausbilden umfaßt:
Aufbringen einer Metallschicht und Musterformen der Metallschicht, um ein Paar erster Elektroden (222, 262) auszubilden,
Aufbringen einer Schicht (427) ferroelektrischen Materials auf die erste Elektrode, und
Aufbringen einer weiteren Metallschicht und Musterformen dieser Metallschicht, um ein Paar zweiter Elektroden (224, 264) entgegengesetzt zu den ersten Elektroden zu bilden; und
das Einstellen das Anlegen von Polungsspannung einer nominalen Polarität zwischen eine (222) der ersten Elektroden und eine entgegengesetzte Elektrode (224) der zweiten Elektroden, und das Anlegen einer Polungsspannung einer entgegengesetzten Polarität zwischen die andere (262) der ersten Elektroden und die andere (264) der zweiten Elektroden umfaßt.

14. Verfahren nach einem der Ansprüche 9 bis 13, das ferner das elektrische Verbinden bestimmter Elektroden der Elektroden umfaßt, die auf entgegengesetzten Seiten des Akustik-Entkopplers angeordnet sind.

## Revendications

1. Transformateur à couplage acoustique (200) comprenant :
un premier résonateur acoustique massif empilé, SBAR, (206) et un second SBAR (208), chaque SBAR comprenant :
une paire empilée de résonateurs acoustiques massifs en couche, FBAR, (par exemple 210, 220), chacun des FBAR comprenant des électrodes planes opposées (par exemple 212, 214) et une couche (par exemple 216) de matériau piézoélectrique entre les électrodes, le matériau piézoélectrique ayant un axe c (par exemple 246), et
un découpleur acoustique (par exemple 230) entre les FBAR ; un premier circuit électrique (241) reliant l'un (210) des FBAR du premier SBAR à l'un (250) des FBAR du second SBAR ; et
un second circuit électrique (242) reliant l'autre (250) des FBAR du premier SBAR à l'autre (260) des FBAR du second SBAR ;
dans lequel l'axe c (par exemple 248) du matériau piézoélectrique de l'un des FBAR (par exemple 250) est de direction opposée aux axes c (246, 247, 249) du matériau piézoélectrique des trois autres FBAR (210, 220, 260).

2. Transformateur selon la revendication 1, dans lequel :
le premier circuit électrique relie l'un des FBAR du premier SBAR en parallèle avec l'un des FBAR du second SBAR ;
le second circuit électrique relie l'autre des FBAR du premier SBAR en série avec l'autre des FBAR du second SBAR.

3. Transformateur selon la revendication 1 ou 2, dans lequel chacun des découpleurs acoustiques comprend une couche (231) de matériau de découplage acoustique.

4. Transformateur selon la revendication 3, dans lequel le matériau de découplage acoustique comprend de la matière plastique.

5. Transformateur selon la revendication 3, dans lequel le matériau de découplage acoustique est électriquement conducteur.

6. Transformateur selon la revendication 3, 4 ou 5, dans lequel :
le transformateur a une bande passante **caractérisée par** une fréquence centrale ; et
la couche de matériau de découplage acoustique a une épaisseur nominale égale à un multiple entier impair du quart de la longueur d'onde dans le matériau de découplage acoustique d'une onde acoustique ayant une fréquence égale à la fréquence centrale.

7. Transformateur selon la revendication 1 ou 2, dans lequel chacun des découpleurs acoustiques a une structure de Bragg (261). ,

8. Transformateur selon l'une quelconque des revendications précédentes, comprenant en outre une connexion électrique entre des électrodes disposées sur les côtés opposés des découpleurs acoustiques.

9. Procédé de fabrication d'un transformateur à couplage acoustique (200), ce procédé comprenant :
fabriquer un premier résonateur acoustique massif empilé, SBAR, (206) et un second SBAR (208), la fabrication comprenant :
fabriquer des résonateurs acoustiques massifs de couche inférieure, FBAR, (210, 250), des FBAR supérieurs (220, 260) et des découpleurs acoustiques (230, 270) entre les FBAR inférieurs et les FBAR supérieurs, chacun des FBAR comprenant des électrodes planes opposées (par exemple 212, 214) et une couche (par exemple 216) de matériau piézoélectrique entre elles, le matériau piézoélectrique ayant un axe c (par exemple 246), la fabrication comprenant le réglage de l'axe c (248) du matériau piézoélectrique de l'un des FBAR (250) en sens opposé aux axes c (246, 247, 249) du matériau piézoélectrique des trois autres FBAR (210, 220, 260) ;
connecter électriquement l'un des FBAR (par exemple 210) du premier SBAR (206) à l'un des FBAR (par exemple 250) du second SBAR (208) ; et
connecter électriquement l'autre des FBAR (par exemple 220) du premier SBAR à l'autre des FBAR (par exemple 260) du second SBAR.

10. Procédé selon la revendication 9, dans lequel :
la fabrication comprend :
déposer et graver une couche métallique pour définir une paire d'électrodes (par exemple 212, 252), et
déposer une couche (par exemple 217) de matériau piézoélectrique sur les électrodes ; et
le réglage comprenant le dépôt d'une couche de germe (255) de matériau piézoélectrique d'axe c inverse sur l'une (par exemple 252) des électrodes avant dépôt de la couche de matériau piézoélectrique.

11. Procédé selon la revendication 10, dans lequel :
le dépôt de la couche de germe est effectué dans de premières conditions de dépôt qui favorisent la formation du matériau d'axe c inverse ; et
le dépôt de la couche de matériau piézoélectrique est réalisé dans de secondes conditions de dépôt qui favorisent la formation du matériau d'axe c normal ; la région (par exemple 256) de la couche déposée sur la couche de germe étant un matériau d'axe c inverse indépendamment de son dépôt dans les secondes conditions de dépôt.

12. Procédé selon la revendication 9, dans lequel :
la fabrication comprend :
déposer et graver une couche métallique pour définir une paire d'électrodes (par exemple 212, 252), et
déposer une couche de matériau piézoélectrique sur les électrodes, la couche comprenant une région (par exemple 256) de matériau d'axe c inverse sur l'une des (par exemple 252) des électrodes et une région (par exemple 216) de matériau d'axe c normal sur l'autre des électrodes (par exemple 212) ; et
le réglage comprend le dépôt des régions en utilisant des conditions de dépôt différentes.

13. Procédé selon la revendication 9, dans lequel :
la formation comprend :
déposer une couche métallique et la graver pour définir une première paire d'électrodes (par exemple 222, 262);
déposer une couche (par exemple 427) de matériau ferroélectrique sur les premières électrodes ; et
déposer une couche métallique supplémentaire et la graver pour définir la paire de secondes électrodes (par exemple 224, 264) opposée aux premières électrodes ; et
le réglage comprend l'application d'une tension de polarisation de polarité nominale entre l'une (par exemple 222) des premières électrodes et l'une opposée (par exemple 224) des secondes électrodes et une tension de polarisation de polarité opposée sur l'autre (par exemple 262) des premières électrodes et l'autre (par exemple 264) des secondes électrodes.

14. Procédé selon l'une quelconque des revendications 9 à 13, comprenant en outre la connexion électrique des premières des électrodes disposées sur les côtés opposés des découpleurs acoustiques.
